# EUROPEAN PATENT APPLICATION

(11) **EP 2 884 531 A2**
(43) Date of publication of application: **17.06.2015**
(21) Application number: 13198417.1
(22) Date of filing: 19.12.2013
(51) Int. Cl.: H01L 23/485, H01L 23/48, H01L 21/60, H01L 21/768, C25D 3/64

(54) **Semiconductor structure comprising a silver alloy pillar, redistribution layer or via and method of manufacturing it using a cyanide-based plating bath**

(30) Priority: 13.12.2013 US 201314106462
(71) Applicant: Chipmos Technologies Inc., Hsinchu (TW)
(72) Inventor: Cheng, Shih Jye, Hsinchu (TW); Lu, Tung Bao, Hsinchu (TW)
(74) Representative: 2K Patentanwälte Blasberg Kewitz & Reichel

(57) **Abstract**

A semiconductor structure includes a device (100), a conductive pad (102) over the device (100) and a Ag₁₋ₓYₓ alloy pillar (101) disposed on the conductive pad (102). Alternatively, a semiconductor structure (800) includes a device (801), a conductive pad (802) on the device (801), a passivation layer (803) disposed over the device (801) and covering a portion of the conductive pad (802) and a redistribution layer (RDL) (806) including Ag₁₋ₓYₓ alloy disposed over the passivation layer (803). Alternatively, a semiconductor structure includes a die (501) including a first surface (501A) and a second surface (501B) opposite to the first surface (501A) and a via (503) passing through the die (501) from the first surface (501A) to the second surface (501B), a Ag₁₋ₓYₓ alloy filling the via (503). The Y of the Ag₁₋ₓYₓ alloy comprises metals forming complete solid solution with Ag at arbitrary weight percentage (Au and/or Pd) and the x of the Ag₁₋ₓYₓ alloy is in a range of from about 0.005 to about 0.25. A method for manufacturing the semiconductor structure includes preparing a cyanide-base plating solution including at least one of KAg(CN)₂, KAu(CN)₂, K₂Pd(CN)₄, immersing the semiconductor structure into the plating solution, applying an electroplating current density of from about 0.1 ASD to about 1.0 ASD to the semiconductor structure to reduce silver ions, gold ions or palladium ions from the plating solution and forming the Ag₁₋ₓYₓ alloy structure (101, 806, 503) on the semiconductor structure.

## Description

### FIELD OF INVENTION

The disclosure relates to a semiconductor structure and the manufacturing method thereof.

### BACKGROUND OF INVENTION

With the recent advancement of the electronics industry, electronic components are being developed to have high performance and thus there is a demand for miniaturized and highly-densified packages. Accordingly, interposers which functions to connect ICs to a main board must be packed more densely. The high densification of packages is attributable to an increase of the number of I/Os of ICs, and the method for the connection with the interposers has also been made more efficient.

The growing popularity of one of the interposer technology is flip-chip bonding. Flip-chip assembly in the fabrication process flow of silicon integrated circuit (IC) devices is driven by several facts. First, the electrical performance of the semiconductor devices can be improved when the parasitic inductances correlated with conventional wire bonding interconnection techniques are reduced. Second, flip-chip assembly provides higher interconnection densities between chip and package than wire bonding. Third, flip-chip assembly consumes less silicon "real estate" than wire bonding, and thus helps to conserve silicon area and reduce device cost. And fourth, the fabrication cost can be reduced, when concurrent gang-bonding techniques are employed rather than consecutive individual bonding steps.

In order to reduce interposer's size and its pitch, efforts were undertaken to replace the earlier solder-based interconnecting balls in flip-chip bonding with metal bumps, especially by an effort to create metal bumps by a modified wire ball technique. Typically, the metal bumps are created on an aluminum layer of the contact pads of semiconductor chips. Subsequently, the chips are attached to substrates using solder. The metal bumps are used for flip chip packaging with applications for LCDs, memories, microprocessors and microwave RFICs.

### BRIEF DESCRIPTION OF THE DRAWINGS

Aspects of the present disclosure are best understood from the following detailed description when read with the accompanying figures. It is emphasized that, in accordance with the standard practice in the industry, various features are not drawn to scale. In fact, the dimensions of the various features may be arbitrarily increased or reduced for clarity of discussion.
- FIG. 1: is a cross sectional view of a silver alloy bump structure in accordance with some embodiments of the present disclosure;
- FIG. 2: is a grain size dispersion curve in accordance with some embodiments of the present disclosure;
- FIG. 3: is a cross sectional view of a silver alloy bump structure in accordance with some embodiments of the present disclosure;
- FIG. 4: is a cross sectional view of a multiplayer bump structure in accordance with some embodiments of the present disclosure;
- FIG. 5: is a cross sectional view of a silver pillar structure with a covering member in accordance with some embodiments of the present disclosure;
- FIG. 6: is a cross sectional view of a chip-on-film (COF) semiconductor structure with a silver alloy bump structure in accordance with some embodiments of the present disclosure;
- FIG. 7: is an enlarged view of a joint portion shown in FIG. 6 in accordance with some embodiments of the present disclosure;
- FIG. 8: is a cross sectional view of a chip-on-film (COF) semiconductor structure with a multiplayer bump structure in accordance with some embodiments of the present disclosure;
- FIG. 9: is an enlarged view of a joint portion shown in FIG. 8 in accordance with some embodiments of the present disclosure;
- FIG. 10: is a cross sectional view of a chip-on-film (COF) semiconductor structure with a silver alloy pillar and a covering member in accordance with some embodiments of the present disclosure;
- FIG. 11: is a cross sectional view of a chip-on-glass (COG) semiconductor structure with a silver alloy bump structure in accordance with some embodiments of the present disclosure;
- FIG. 12: is a cross sectional view of a chip-on-glass (COG) semiconductor structure with a multiplayer bump structure in accordance with some embodiments of the present disclosure;
- FIG. 13: is a cross sectional view of a chip-on-glass (COG) semiconductor structure with a multilayer bump structure in accordance with some embodiments of the present disclosure;
- FIG. 14 to FIG. 20: show the operations of manufacturing a silver alloy pillar structure in accordance with some embodiments of the present disclosure;
- FIG. 21: is a top view of a semiconductor structure with a redistribution layer (RDL) in accordance with some embodiments of the present disclosure;
- FIG. 22: is a cross sectional view of a semiconductor structure with a redistribution layer (RDL) along AA' of FIG. 21 in accordance with some embodiments of the present disclosure;
- FIG. 23: is a cross sectional view of a semiconductor structure with a redistribution layer (RDL) including a metal layer in accordance with some embodiments of the present disclosure;
- FIG. 24 to FIG. 31: show the operations of manufacturing a redistribution layer (RDL) in accordance with some embodiments of the present disclosure;
- FIG. 32: is a cross sectional view of a die with several through silicon vias (TSVs) in accordance with some embodiments of the present disclosure;
- FIG. 33: is a cross sectional view of several dies stacked and connected with each other by through silicon vias (TSVs) in accordance with some embodiments of the present disclosure;
- FIG. 34: is a cross sectional view of several stacked dies mounted on a substrate in accordance with some embodiments of the present disclosure;
- FIG. 35 to FIG. 41: show the operations of manufacturing a through silicon via (TSV) plated with a silver alloy in accordance with some embodiments of the present disclosure;
- FIG. 42: is a top view of a dual flat no-leads (DFN) package in accordance with some embodiments of the present disclosure;
- FIG. 43: is a cross sectional view of a dual flat no-leads (DFN) package along BB' of FIG. 42 in accordance with some embodiments of the present disclosure; and
- FIG. 44: is a cross sectional view of a flip chip ball grid array (FCBGA) package with a silver alloy pillar in accordance with some embodiments of the present disclosure.

### DETAILED DESCRIPTION OF THE INVENTION

In the following detailed description, numerous specific details are set forth in order to provide a thorough understanding of the invention. However, it will be understood by those skilled in the art that the present invention may be practiced without these specific details. In other instances, well-known methods, procedures, components and circuits have not been described in detail so as not to obscure the present invention. It is to be understood that the following disclosure provides many different embodiments or examples for implementing different features of various embodiments. Specific examples of components and arrangements are described below to simplify the present disclosure. These are, of course, merely examples and are not intended to be limiting.

The making and using of the embodiments are discussed in detail below. It should be appreciated, however, that the present invention provides many applicable inventive concepts that can be embodied in a wide variety of specific contexts. The specific embodiments discussed are merely illustrative of specific ways to make and use the invention, and do not limit the scope of the invention.

Among the metal bump technology in semiconductor packaging, gold bumps gained most popularity in that the familiarity to the material properties and processing technology in the art. However, high material cost, inferior bonding reliability and unsatisfactory material properties such as low electrical conductivity and low thermal conductivity remain as problems to be solved. An alternative cost-saving approach to fabricate metal bump is by creating multilayer bumps, for example, a Cu (bottom layer), Ni (middle layer) and Au (top layer) bump. This approach saves the gold material consumption for a metal bump but the Cu bottom layer is subject to easy oxidation and corrosion, and thus generates reliability concerns.

When the gold bumps are joined to the substrate pads by reflowing the solder that has been deposited on the pads, a number of gold/tin intermetallics are formed. Because of the high dissolution rate of gold in the molten solders, the solder joints with gold bumps have, after one reflow, a large volume fraction of intermetallic compounds, with AuSn₄ the major phase that greatly embrittle the joints. After two or more reflows, which are typically needed for assembling package-on-package products, the gold bumps may be completely consumed and converted into gold/tin intermetallic compounds. Because of the brittleness of these compounds and the direct contact of the intermetallics with the aluminum pad on the chip side, the joints frequently fail reliability tests such as the mechanical drop test by cracking at the bump/chip interface.

Silver bump is one twentieth of the cost of the gold bump, and silver bump possesses the highest electrical conductivity and the highest thermal conductivity of the three metals discussed herein (Au, Cu, Ag). In addition, the annealing temperature of the silver bump is lower than that of the gold bump, thus greatly reduce the risk of passivation crack. As far as solder-joint the silver bump to a substrate is concerned, at a temperature higher than the eutectic temperature, silver/tin interface demonstrates a superior bonding property than that of the gold/tin interface. In some embodiments of the present disclosure, silver alloy is utilized for silver bump to avoid silver needle, silver migration, oxidation and vulcanization problems inherent to pure silver.

Some embodiments of the present disclosure provide a semiconductor structure having a silver alloy bump. The silver alloy bump can be a binary alloy or a ternary alloy with 0.005 to 0.25 atomic percent of non-silver elements. In some embodiments, because the silver alloy bump is formed by electroplating, a uniform grain size distribution is observed and can be quantified by measuring a standard deviation of the grain size distribution.

Some embodiments of the present disclosure provide a semiconductor structure having a multilayer alloy bump containing silver. The multilayer alloy bump includes a binary alloy or a ternary alloy with 0.005 to 0.25 atomic percent of non-silver elements. In some embodiments, an additional metal layer including gold (Au) is positioned over the binary alloy or a ternary alloy. In some embodiments, the additional metal layer covers a sidewall of the binary alloy or a ternary alloy. In some embodiments, because the multilayer alloy bump is formed by electroplating, a uniform grain size distribution is observed and can be quantified by measuring a standard deviation of the grain size distribution.

Some embodiments of the present disclosure provide a tape automated bonding (TAB) semiconductor structure including an electroplated silver alloy bump. In some embodiments, a chip-on-film (COF) structure includes a silver/tin interface between the silver alloy bump and the conductive copper line on the film. In some embodiments, an additional metal layer is positioned over the electroplated silver alloy bump in the COF structure. In some embodiments, the additional metal layer covers a sidewall of the electroplated silver alloy bump in the COF structure.

Some embodiments of the present disclosure provide a chip-on-glass (COG) structure including an electroplated Ag₁₋ₓYₓ alloy bump electrically couple a semiconductor chip to a conductive layer. In some embodiments, the Y of the electroplated Ag₁₋ₓYₓ alloy bump includes at least one of Pd and Au. In some embodiments, an additional metal layer is positioned over the electroplated silver alloy bump in the COG structure. In some embodiments, the additional metal layer covers a sidewall of the electroplated silver alloy bump in the COG structure.

Some embodiments of the present disclosure provide an electroplated silver alloy bump in a semiconductor structure. In some embodiments, a silver alloy thin film made of the electroplated silver alloy bump described herein possesses a thermal conductivity of from about 250 W/(mK) to about 450 W/(mK). In other embodiments, the electroplated silver alloy bump possesses an electrical conductivity of from about 35 (Ωm)⁻¹ to about 65 (Ωm)⁻¹.

Some embodiments of the present disclosure provide a semiconductor structure having a silver alloy pillar disposed on a device of the semiconductor structure. The silver alloy pillar can be a binary alloy or a ternary alloy with 0.005 to 0.25 atomic percent of non-silver elements.

In some embodiments, the silver alloy pillar includes an electroplated Ag₁₋ₓYₓ alloy, wherein Y includes at least one of palladium (Pd) and gold (Au) and X is from about 0.005 to about 0.25. In some embodiments, because the silver alloy pillar is formed by electroplating, a uniform grain size distribution is observed and can be quantified by measuring a standard deviation of the grain size distribution.

Some embodiments of the present disclosure provide a semiconductor structure having a redistribution layer (RDL) disposed over a passivation layer or a device of the semiconductor structure. The RDL includes a silver alloy which can be a binary alloy or a ternary alloy with 0.005 to 0.25 atomic percent of non-silver elements.

In some embodiments, the RDL includes an electroplated Ag₁₋ₓYₓ alloy, wherein Y includes at least one of palladium (Pd) and gold (Au) and X is from about 0.005 to about 0.25. In some embodiments, an additional metal layer including gold (Au) is disposed on the silver alloy.

Some embodiments of the present disclosure provide a semiconductor structure having several vias plated with a silver alloy and passed through a die or an interposer as "through silicon vias (TSV)", so that one side of the die is configured for electrically connecting another die. In some embodiments, the silver alloy can be a binary alloy or a ternary alloy with 0.005 to 0.25 atomic percent of non-silver elements. In some embodiments, the silver alloy includes an electroplated Ag₁₋ₓYₓ alloy, wherein Y includes at least one of palladium (Pd) and gold (Au) and X is from about 0.005 to about 0.25.

Some embodiments of the present disclosure provide a semiconductor structure having several dies stacked on each other and electrically interconnected by several TSV plated with a silver alloy. In some embodiments, the silver alloy can be a binary alloy or a ternary alloy with 0.005 to 0.25 atomic percent of non-silver elements. In some embodiments, the silver alloy includes an electroplated Ag₁₋ₓYₓ alloy, wherein Y includes at least one of palladium (Pd) and gold (Au) and X is from about 0.005 to about 0.25.

Some embodiments of the present disclosure provide a semiconductor structure in a semiconductor package. In some embodiments, the semiconductor package is a flip chip dual flat no leads (FCDFN) package including a flip chip die electrically connecting with several flat no leads by several silver alloy pillars. In some embodiments, the silver alloy can be a binary alloy or a ternary alloy with 0.005 to 0.25 atomic percent of non-silver elements. In some embodiments, the silver alloy includes an electroplated Ag₁₋ₓYₓ alloy, wherein Y includes at least one of palladium (Pd) and gold (Au) and X is from about 0.005 to about 0.25.

Some embodiments of the present disclosure provide a semiconductor structure in a semiconductor package. In some embodiments, the semiconductor package is a flip chip ball grid array (FCBGA) package including a flip chip die electrically connecting with several conductive pads disposed on a substrate by several silver alloy pillars. In some embodiments, the silver alloy can be a binary alloy or a ternary alloy with 0.005 to 0.25 atomic percent of non-silver elements. In some embodiments, the silver alloy includes an electroplated Ag₁₋ₓYₓ alloy, wherein Y includes at least one of palladium (Pd) and gold (Au) and X is from about 0.005 to about 0.25.

### Definitions

In describing and claiming the present disclosure, the following terminology will be used in accordance with the definitions set forth below.

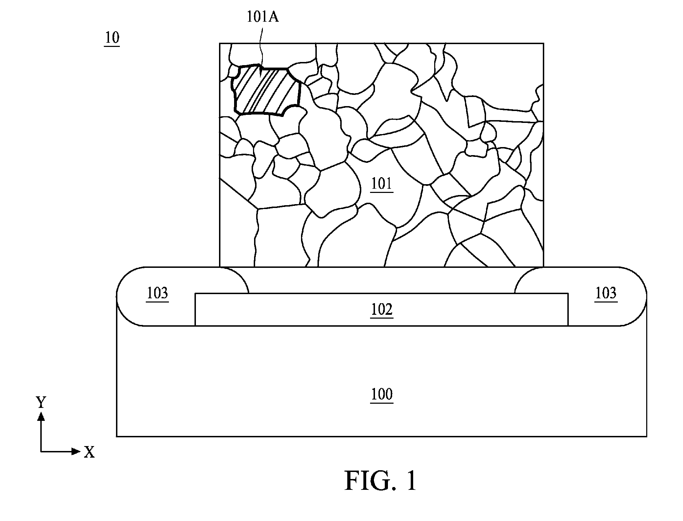

As used herein, an "average grain size" is measured by any conventional grain size measurement techniques such as X-ray diffraction (XRD), electron beam scattering pattern (EBSP), transmission electron microscopy (TEM), or scanning electron microscopy (SEM). A pretreated cross sectional plane of the sample is prepared for the grain size measurements discussed in this disclosure. The cross sectional planes subjected to any of the measurements discussed herein is any planes passing through a silver alloy bump 101 of a silver alloy bump structure 10 having a plane normal perpendicular to a longitudinal direction parallel to a Y direction as shown in FIG. 1.

As used herein, an "electron beam scattering pattern (EBSP)" used for average grain size measurement is aided by a computer analysis program (for example, TSL OIM analysis). The setting of the computer analysis program includes, but not limited to, grain boundary misorientation of 15 degrees, CI value equal to or greater than 0.1, and minimal grain size of at least 5 testing points. In some embodiments, The average grain size of the EBSP measurement is obtained by averaging the grain sizes at least on three different testing locations of the cross sectional plane. A predetermined area is measured in each testing location. The predetermined area varies in accordance with features of different embodiments. Each testing location is at least 1mm away from the adjacent testing location. In some embodiments, an interval between each measuring points in one testing location is at least 5µm. In some embodiments, the prepared sample subjected to the EBSP measurement is observed under an accelerating voltage of 20kV and a magnification of 100X to 500X. In some embodiments, the prepared sample is positioned at a tilting angle of 70 degree.

As used herein, "transmission electron microscopy (TEM), or scanning electron microscopy (SEM)" used for average grain size measurement is aided by an image analysis program (for example, CLEMEX Vision PE). In some embodiments, The average grain size of the TEM or SEM measurement is obtained by averaging the grain sizes at least on three different testing locations of the cross sectional plane. A predetermined area is measured in each testing location. The predetermined area varies in accordance with features of different embodiments. Each testing location is at least 1mm away from the adjacent testing location. In some embodiments, the interval between each measuring points in one testing location is at least 5µm. In some embodiments, the prepared sample subjected to the TEM or SEM measurement is observed under an accelerating voltage of from about 5kV to about 20kV and a magnification of 100X to 500X.

As used herein, "standard deviation of grain size distribution" of the silver alloy bump refers to a statistical result which is obtained using an image analysis program discussed herein. After obtaining a dispersion curve of the grain size distribution, one standard deviation is defined as a grain size deviated from a mean grain size (expectation value), wherein the number of the grain having a grain size between the deviated grain size and the mean grain size is accountable for 34% of the total number of grains.

As used herein and in particular in the appended claims, values X introduced by the term "about" (i.e. about X) may, of course, also include the precise value, and parameter ranges "from about X to about Y" may, of course, also include the precise parameter ranges (i.e. "from X to Y"). The person skilled in the art will certainly become aware from the foregoing that within the general solution of the present invention and the scope of the appended claims such values or parameter ranges will, or course, also cover slight deviations from such precise values or parameter ranges, as long as such slight deviations make use of the general solution of the present invention and the scope of the appended claims.

FIG. 1 is a cross section of a silver alloy bump structure 10 with a silver alloy bump 101 connected to a conductive pad 102. The silver alloy bump 101 and the conductive pad 102 are positioned on a device 100. In some embodiments, the device 100 includes, but not limited to, active devices such as a memory, a transistor, a diode (PN or PIN junctions), integrated circuits or a varactor. In other embodiments, the device 100 includes passive devices such as a resistor, a capacitor or an inductor.

A microstructure of the silver alloy bump 101 is shown in FIG. 1. A cross section of the silver alloy bump 101 is prepared by cutting the silver alloy bump structure 10 along a longitudinal direction (Y direction) and thus an XY surface is obtained. Using an electronic microscope, grain structure of the silver alloy bump 101 is identified on the XY surface, and with a help of image analysis software discussed herein, the statistical information of the grain size distribution can be obtained.

Referring to FIG. 1, an area of a grain 101A is shaded with straight lines. The SEM picture shown in the silver alloy bump 101 is taken from a real cross sectional plane of the silver alloy bump 101 described herein. In some embodiments, because the silver alloy bump 101 is formed by an electroplating operation, grain size distribution is rather uniform and no heat-affected zone (HAZ) is observed as those in a stud bump (not shown). HAZ produces abrupt change in the grain size due the fact that the grain growth procedure is subject to a local high temperature. Normally, the grain size obviously increases in the HAZ. In some embodiments of the present disclosure, sub-grain structures can be identified in the grains of the silver alloy bump 101. For example, in the grain 101A, sub-grain domains are visible in a way that several regions within the grain 101A separated by domain boundaries can be identified.

In some embodiments, the silver alloy bump 101 includes Ag₁₋ₓYₓ alloy. Specie Y in the Ag₁₋ₓYₓ alloy includes a metal forming complete solid solution with silver at an arbitrary weight percentage. In some embodiments, specie Y can be identified from a binary phase diagram. A liquidus line and a solidus line forming a lens shape in the binary phase diagram indicate a complete mix of solid solution at any composition of the two metal components. For example, in some embodiments of the present disclosure, specie Y is gold (Au), palladium (Pd), or the combination thereof. In some embodiments, Ag₁₋ₓYₓ alloy is binary metal alloys such as Ag₁₋ₓAuₓ or Ag₁₋ₓPdₓ. In some embodiments, Ag₁₋ₓYₓ alloy is ternary metal alloy such as Ag₁₋ₓ(AuPd)ₓ. In some embodiments, the content of the specie Y in the Ag₁₋ₓYₓ alloy is ranged from about 0.005 to about 0.25 in atomic percent.

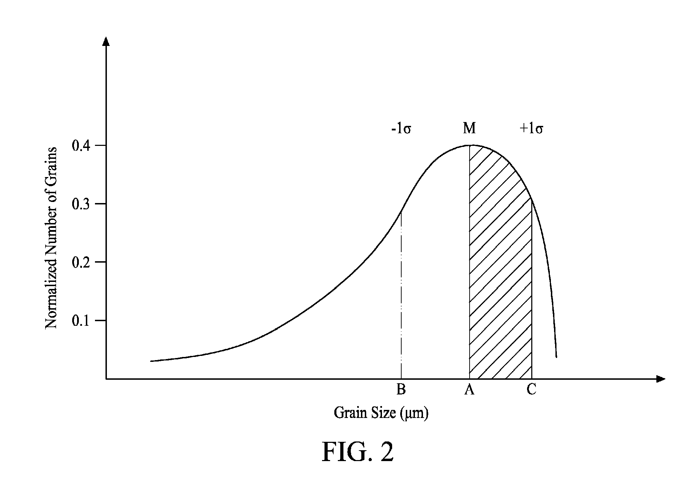

In some embodiments, the grain size of the silver alloy bump 101 in FIG. 1 forms a dispersion curve as shown in FIG. 2. The dispersion curve in FIG. 2 is obtained through image analysis software program such as, but not limited to, CLEMEX Vision PE. In FIG. 2, an X-axis of the dispersion curve indicates grain size in micrometer (µm), whereas a Y-axis of the dispersion curve shows normalized number of grains. Grain size calculation in the present disclosure is aided by a computer analysis program (for example, TSL OIM analysis). In some embodiments, the computer analysis program convert the area of a grain into a hypothetical circle having a same area, and a diameter of such hypothetical circle is defined as a grain size with a unit in length (usually in micrometer). However, the grain size calculation is not limited to the operation described above. In other embodiments, an average grain size is obtained by drawing a diagonal line on a TEM picture or an SEM picture of a cross sectional plane of the silver alloy bump structure described herein, and divide a length of the diagonal line by the number of grains said diagonal line encounters. Any grain size measurement operation is suitable as long as it is aided by computer software or it is conducted under a consistent and systematic manner.

After plotting out the dispersion curve as shown in FIG. 2, a standard deviation can be measured as a morphology feature of the microstructure of the silver alloy bump 101. In some embodiments, the dispersion curve has a skewed bell shape which possesses a maximum closer to a right end of the dispersion curve. In some embodiments, a mean value or an expectation value of the grain size is represented by a maximum of the dispersion curve. As shown in FIG. 2, the mean value M corresponds to a grain size A, which, in some embodiments, is in a range of from about 0.7µm to about 0.8µm. One standard deviation away from the mean value M to a positive direction (+1 *σ*) corresponds to a grain size C, which, in some embodiments, is in a range of from about 1.0µm to about 1.1µm. One standard deviation away from the mean value M to a negative direction (-1 *σ*) corresponds to a grain size B, which, in some embodiments, is in a range of from about 0.4µm to about 0.5µm. In some embodiments, one standard deviation is defined as a grain size deviated from the mean value M, and wherein the number of the grain having a grain size between the deviated grain size B or C and the mean value M is accountable for 34% of the total number of grains. Note the dispersion curve obtained from actual grain size measurement does not have to be symmetric about the mean value M, and hence in some embodiments, a difference between one standard deviation away from the mean value M to a positive direction (+1 *σ*) at grain size C and the mean value M is not necessarily the same as a difference between one standard deviation away from the mean value M in a negative direction (-1 *σ*) at grain size B and the mean value M.

In some embodiments of the present disclosure, a difference between grain size C and grain size A is about from 0.2µm to about 0.4µm. In other embodiments, a difference between grain size B and grain size A is about from 0.2 to about 0.4µm. By utilizing the electroplating operation discussed in the present disclosure, the grain size of the silver alloy bump 101 demonstrates a uniform distribution and a difference between one standard deviation away from the mean value M (to the positive or to the negative direction) can be quantified as within a range of from about 0.2 µm to about 0.4 µm.

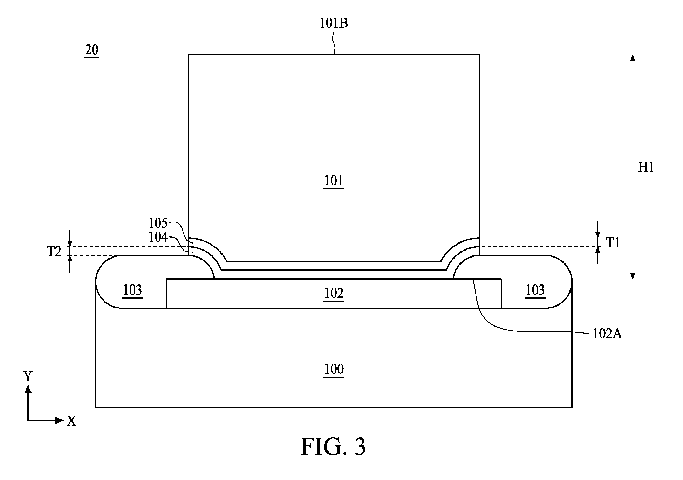

Referring to FIG. 3, a cross section of a silver alloy bump structure 20 is shown. Compared to the silver alloy bump structure 10 in FIG. 1, the silver alloy bump structure 20 further includes an under bump metallization (UBM) layer 104 and a seed layer 105. In some embodiments, the seed layer 105 contains silver or silver alloy. In some embodiments, the seed layer 105 is prepared by a suitable operation such as chemical vapor deposition (CVD), sputtering, electroplating or etc. In some embodiments, the UBM layer 104 has a single-layer structure or a composite structure including several sub-layers formed of different materials, and includes a layer(s) selected from a nickel (Ni) layer, a titanium (Ti) layer, a titanium tungsten (W) layer, a palladium (Pd) layer, a gold (Au) layer, a silver (Ag) layer, and combinations thereof.

As shown in FIG. 3, a height H1 of the silver alloy bump 101 is measured from a top surface 101B of the silver alloy bump 101 to a top surface 102A of the conductive pad 102. In some embodiments, the height H1 of the silver alloy bump 101 or the Ag₁₋ₓYₓ alloy is in a range of from about 9 µm to about 15 µm. In proportionate of the height H1 of the silver alloy bump 101, a thickness T2 of the UBM layer 104 is commensurate to a thickness T1 of the seed layer 105. In some embodiments, a thickness T2 of the UBM layer 104 is in a range of from about 1000A to about 3000A, and a thickness T1 of the seed layer 105 is in a range of from about 1000A to about 3000A.

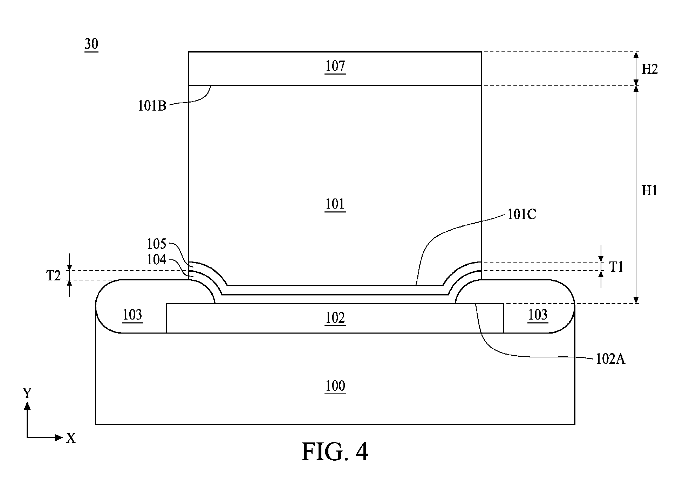

Referring to FIG. 4, a cross section of a multilayer bump structure 30 is shown. Compared to the silver alloy bump structure 20 in FIG. 3, the multilayer bump structure 30 further includes a metal layer 107 over the top surface 101B of the silver alloy bump 101. In some embodiments, the multilayer bump structure 30 includes the silver alloy bump 101 having a bottom surface 101C disposed over a seed layer 105, an UBM layer 104 and a conductive pad 102. Thus, the metal layer 107, the silver alloy bump 101, the seed layer 105, the UBM layer 104 and the conductive pad 102 are electrically connected with each other. In some embodiments, the metal layer 107 and the silver alloy bump 101 are electrically connected to a device 100 through the seed layer 105, the UBM layer 104 and the conductive pad 102.

In some embodiments, the metal layer 107 includes metallic materials other than silver. In other embodiments, the metal layer 107 includes gold. A thickness H2 of the metal layer 107 is thick enough to form a joint interface between the silver alloy bump 101 and a circuitry of an external device such as a die, a substrate, a package, a printed circuit board (PCB) or etc. In some embodiments, a thickness H2 of the metal layer 107 is from about 1µm to about 3µm, and the metal layer 107 is formed by an electroplating operation.

In FIG. 4, the multilayer bump structure 30 includes the under bump metallization (UBM) layer 104 and the seed layer 105. In some embodiments, the seed layer 105 contains silver or silver alloy and is prepared by a suitable operation such as chemical vapor deposition (CVD), sputtering, electroplating or etc. In some embodiments, the UBM layer 104 has a single-layer structure or a composite structure including several sub-layers formed of different materials, and includes a layer(s) selected from a nickel (Ni) layer, a titanium (Ti) layer, a tungsten (W) layer, a palladium (Pd) layer, a gold (Au) layer, a silver (Ag) layer, and combinations thereof.

The silver alloy bump 101 shown in FIG. 4 includes Ag₁₋ₓYₓ alloy, wherein specie Y is gold, palladium, or the combination thereof. For example, Ag₁₋ₓYₓ alloy can be binary metal alloys such as Ag₁₋ₓAuₓ or Ag₁₋ₓPdₓ, furthermore, Ag₁₋ₓYₓ alloy can be ternary metal alloy such as Ag₁₋ₓ(AuPd)ₓ. In some embodiments, the content of the specie Y in the Ag₁₋ₓYₓ alloy is ranged from about 0.005 to about 0.25 in atomic percent. In some embodiments, specie Y in the Ag₁₋ₓYₓ alloy includes metal forming complete solid solution with silver at any weight percentage. As shown in FIG. 4, a height H1 of the silver alloy bump 101 is in a range of from about 9µm to bout 15µm.

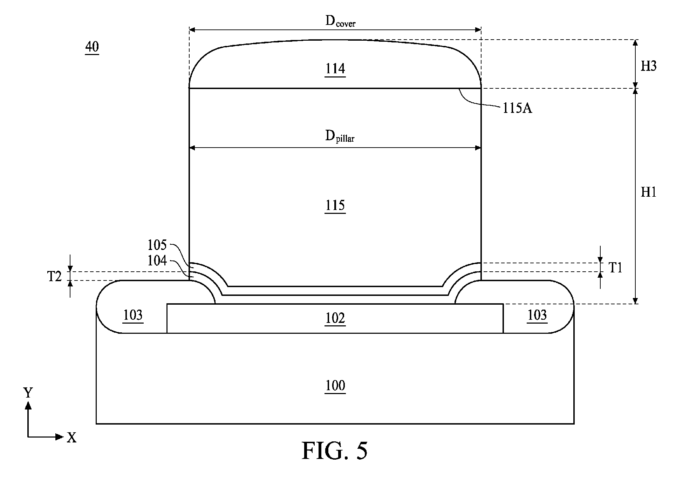

Referring to FIG. 5, a cross section of a silver pillar structure 40 is shown. Compared with the multilayer bump structure 30 in FIG. 4, the silver alloy bump 101 and the metal layer 107 of the multilayer bump structure 30 in FIG. 4 are different from the pillar 115 and a covering member 114 of the silver pillar structure 40 in FIG. 5. Furthermore, the pillar 115 in FIG. 5 and the silver alloy bump 101 in FIG. 4 have substantial difference in size. In some embodiments, the pillar 115 in FIG. 5 has greater size than the silver alloy bump 101 in FIG. 4. The pillar 115 has greater height than the silver alloy bump 101. In some embodiments, the pillar 115 has a height of from about 30µm to about 100µm, while the silver alloy bump 101 has a height of from about 9µm to about 15µm. The elements with identical numeral labels as those shown in FIG. 4 and FIG. 5 are referred to same elements or their equivalents and are not repeated here for simplicity.

In some embodiments, the pillar 115 is disposed on a conductive pad 102 including a seed layer 105 and a UBM layer 104. In some embodiments, the pillar 115, the seed layer 105, the UBM layer 104 are electrically connected with a device 100. In some embodiments, the seed layer 105 includes silver or silver alloy interfaced with the pillar 115.

In some embodiments, the pillar 115 includes Ag₁₋ₓYₓ alloy as a Ag₁₋ₓYₓ alloy pillar, wherein specie Y is gold, palladium, or the combination thereof. For example, Ag₁₋ₓYₓ alloy can be binary metal alloys such as Ag₁₋ₓAuₓ or Ag₁₋ₓPdₓ, furthermore, Ag₁₋ₓYₓ alloy can be ternary metal alloy such as Ag₁₋ₓ(AuPd)ₓ. In some embodiments, the content of the specie Y in the Ag₁₋ₓYₓ alloy is ranged from about 0.005 to about 0.25 in atomic percent. In some embodiments, specie Y in the Ag₁₋ₓYₓ alloy includes metal forming complete solid solution with silver at any weight percentage.

In some embodiments, the Ag₁₋ₓYₓ alloy pillar 115 is formed by any suitable operations such as electroplating, sputtering or the like. As shown in FIG. 5, a height H1 of the Ag₁₋ₓYₓ alloy pillar 115 is in a range of from about 30µm to about 100µm.

In some embodiments, an additional covering member 114 is disposed on a top surface 115A of the Ag₁₋ₓYₓ alloy pillar 115, and thus the covering member 114, the Ag₁₋ₓYₓ alloy pillar 115, the seed layer 105, the UBM layer 104 and a device 100 are electrically connected with each other. In some embodiments, the covering member 114 includes solder material such as tin or silver for electrically connecting with another semiconductor structure. In some embodiments, the covering member 114 is in a hemispherical shape. In some embodiments, the covering member 114 is formed on the Ag₁₋ₓYₓ alloy pillar 115 by any suitable operations such as pasting or electroplating.

In some embodiments, the covering member 114 is a joint interface between the Ag₁₋ₓYₓ alloy pillar 115 and a circuitry of an external device such as a die, a substrate, a package, a printed circuit board (PCB) or etc. In some embodiments, the height H3 of the covering member 114 is from about 1µm to about 5µm. In some embodiments, the covering member 114 has a diameter D_{cover} substantially same as a diameter Dₚᵢₗₗₐᵣ of the Ag₁₋ₓYₓ alloy pillar 115.

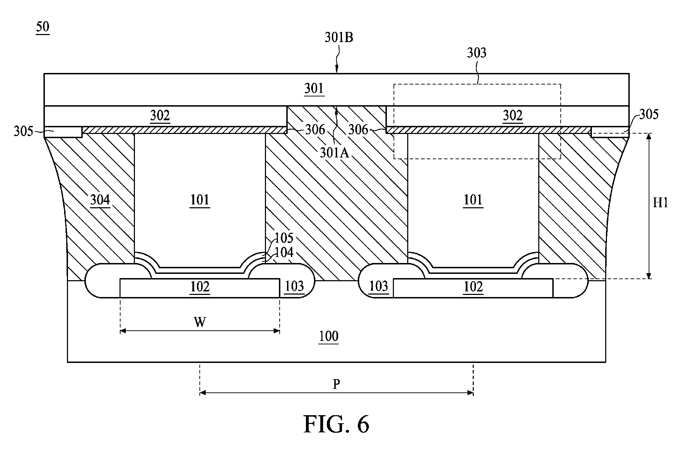

Referring to FIG. 6, a cross section of a chip-on-film (COF) semiconductor package 50 is shown. In some embodiments, the COF semiconductor package 50 includes a flexible film 301 having a first surface 301A and a second surface 301B. The flexible film 301 includes, but not limited to, flexible printed circuit board (FPCB) or polyimide (PI). A conductive layer 302 including a circuitry or a conductive trace is patterned on the first surface 301A of the flexible film 301.

In FIG. 6, elements with identical numeral labels as those shown in FIG. 1 and FIG. 3 are referred to same elements or their equivalents and are not repeated here for simplicity. In FIG. 5, two silver alloy bumps 101 electrically couple the device 100 to the conductive layer 302 of the flexible film 301 to become the COF semiconductor package 50. In some embodiments, an underfill material 304, for example, solventless epoxy resin, with appropriate viscosity is injected into the space between the flexible film 301 and the device 100 to surround the silver alloy bumps 101.

The silver alloy bump 101 shown in FIG. 6 includes Ag₁₋ₓYₓ alloy, wherein specie Y is gold, palladium, or the combination thereof. For example, Ag₁₋ₓYₓ alloy can be binary metal alloys such as Ag₁₋ₓAuₓ or Ag₁₋ₓPdₓ, furthermore, Ag₁₋ₓYₓ alloy can be ternary metal alloy such as Ag₁₋ₓ(AuPd)ₓ. In some embodiments, the content of the specie Y in the Ag₁₋ₓYₓ alloy is ranged from about 0.005 to about 0.25 in atomic percent. In some embodiments, specie Y in the Ag₁₋ₓYₓ alloy includes metal forming complete solid solution with silver at any weight percentage.

As shown in FIG. 6, a height H1 of the silver alloy bump 101 is in a range of from about 9µm to about 15µm, and a pitch P between the adjacent silver alloy bumps 101 is below 10µm. In some embodiments, a width W of the conductive pad 102 is in a range of from about 20µm to about 30µm.

In FIG. 6, a solder resist pattern 305 is positioned on the conductive layer 302. A solder layer 306 is applied on the conductive layer 302 in accordance with the solder resist pattern 305. The solder layer 306 is configured for bonding the silver alloy bump 101 with the conductive layer 302. In some embodiments of the present disclosure, the solder layer 306 includes a conventional solder material, a lead-free solder material or etc.

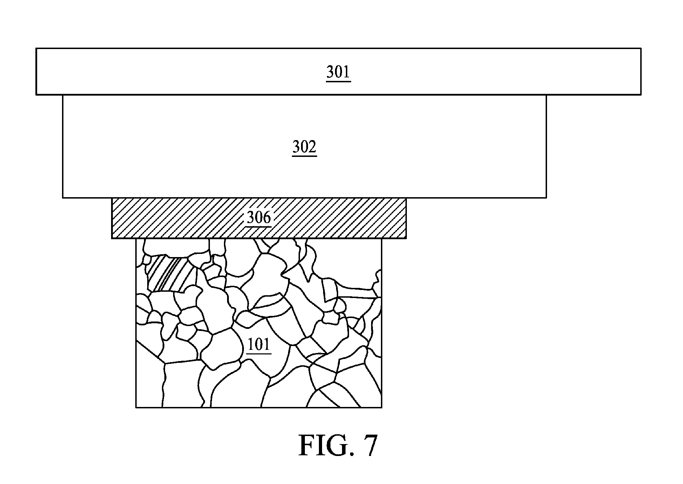

A joint portion in FIG. 6 is surrounded by dotted box 303 and is enlarged as shown in FIG. 7. Referring to FIG. 7, the solder layer 306 includes not only solder material itself but also Ag₁₋ₐSnₐ alloy. In some embodiments, the Ag₁₋ₐSnₐ alloy at least includes Ag_{0.5}Sn_{0.5} alloy. In certain embodiments, when an inner lead bonding (ILB) temperature for the COF set at the silver alloy bump side is about 400 degrees Celsius, the liquid phase of the AgSn alloy system is substantially more than the liquid phase of the AuSn alloy system given the same bonding temperature set at a free end of the alloy bump. Excess liquid phase of the AgSn alloy promotes an adhesion between the silver alloy bump 101 and the conductive layer 302, and hence better junction reliability is obtained in AgSn alloy system by using a Ag-based alloy bump. On the other hand, a lower ILB temperature for the COF can be used in the AgSn alloy system. A lower ILB temperature, for example, lower than 400 degrees Celsius, can prevent the flexible film 301 from deformation or shrinkage. In other embodiments, an anisotropic conductive film (ACF) can be used to connect the silver alloy bump 101 and the conductive layer 302.

Referring to FIG. 7, the microstructure of the silver alloy bump 101 is shown. An average grain size of the silver alloy bump 101 is in a range of from about 0.5µm to about 1.5µm. Because the melting temperature of silver is around 962 degrees Celsius, an annealing temperature applied to the silver alloy bump 101 can be lower than 250 degrees Celsius to avoid the cracking of a passivation layer 103 shown in FIG. 1, FIG. 3, FIG. 4, FIG. 5 and FIG. 6. Compared to a higher melting temperature of gold (1064 degrees Celsius), a lower melting temperature results to a lower annealing temperature, and hence the previously-grown structure such as the passivation layer 103 is subjected to less thermal stress. In some embodiments, after annealing the silver alloy bump 101 under a temperature lower than 250 degrees Celsius, the average grain size of the Ag₁₋ₓYₓ alloy measured by the method described herein is around 1µm.

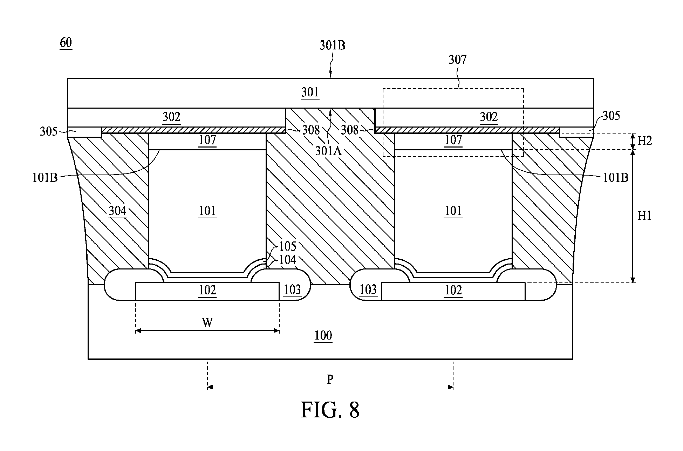

Referring to FIG. 8, a cross section of a chip-on-film (COF) semiconductor package 60 is shown. The COF semiconductor package 60 includes a flexible film 301 having a first surface 301A and a second surface 301B. The flexible film 301 includes, but not limited to, flexible printed circuit board (FPCB) or polyimide (PI). A conductive layer 302 such as a conductive copper trace is patterned on the first surface 301A of the flexible film 301, and a solder resist pattern 305 is positioned on the conductive layer 302. In FIG. 8, elements with identical numeral labels as those shown in FIG. 1, FIG. 3, FIG. 4, FIG. 5 and FIG. 6 are referred to same elements or their equivalents and are not repeated here for simplicity. In FIG. 8, two multilayer bump structures including silver alloy bumps 101 and a metal layer 107, electrically couple the device 100 to the conductive layers 302 of the flexible film 301. In some embodiments, an underfill material 304, for example, solventless epoxy resin, with appropriate viscosity is injected into the space between the flexible film 301 and the device 100. In the case that the metal layer 107 is made of electroplated gold film, the subsequent bonding of the flexible film 301 and the silver alloy bump 101 can utilize the bonding operation conventional in the art for a gold bump.

The silver alloy bump 101 shown in FIG. 8 includes Ag₁₋ₓYₓ alloy, wherein specie Y is gold, palladium, or the combination thereof. For example, Ag₁₋ₓYₓ alloy can be binary metal alloys such as Ag₁₋ₓAuₓ or Ag₁₋ₓPdₓ, furthermore, Ag₁₋ₓYₓ alloy can be ternary metal alloy such as Ag₁₋ₓ(AuPd)ₓ. In some embodiments, the content of the specie Y in the Ag₁₋ₓYₓ alloy is ranged from about 0.005 to about 0.25 in atomic percent. In some embodiments, specie Y in the Ag₁₋ₓYₓ alloy includes a metal forming complete solid solution with silver at any weight percentage. The metal layer 107 shown in FIG. 8 includes metallic materials other than silver, for example, gold.

As shown in FIG. 8, a height H1 of the silver alloy bump 101 is in a range of from about 9µm to bout 15µm, and a pitch P between the adjacent silver alloy bumps 101 is below 10µm. A height H2 of the metal layer 107 is in a range of from about 1µm to bout 3µm. In some embodiments, a width W of the conductive pad 102 is in a range of from about 20µm to about 30µm.

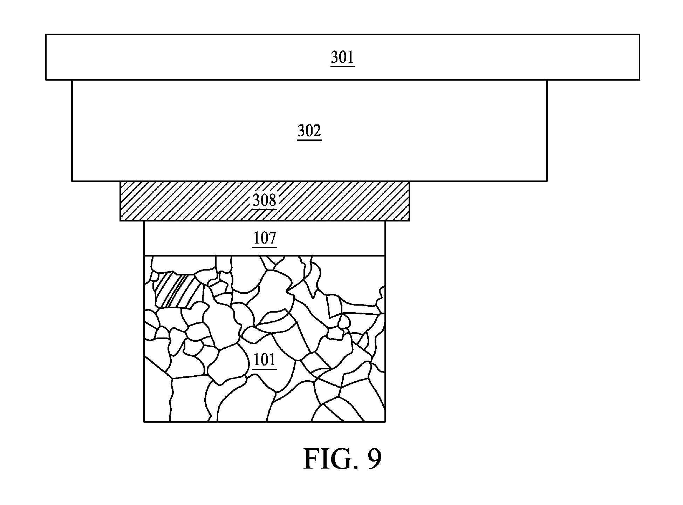

In FIG. 8, a solder resist pattern 305 is positioned on the conductive layer 302. A solder layer 308 is applied to a joint of the metal layer 107 and the conductive layer 302. In some embodiments of the present disclosure, the solder layer 308 is a conventional solder material or lead-free solder. A joint portion in FIG. 8 surrounded by dotted box 307 is enlarged and shown in FIG. 9. Referring to FIG. 9, the solder layer 308 includes not only solder material itself but also Au₁₋ₐSnₐ alloy if the metal layer 107 is made of gold (Au). In some embodiments, the Au₁₋ₐSnₐ alloy at least includes Au_{0.5}Sn_{0.5} alloy. In other embodiments, an anisotropic conductive film (ACF) can be used to connect the metal layer 107 and the conductive layer 302.

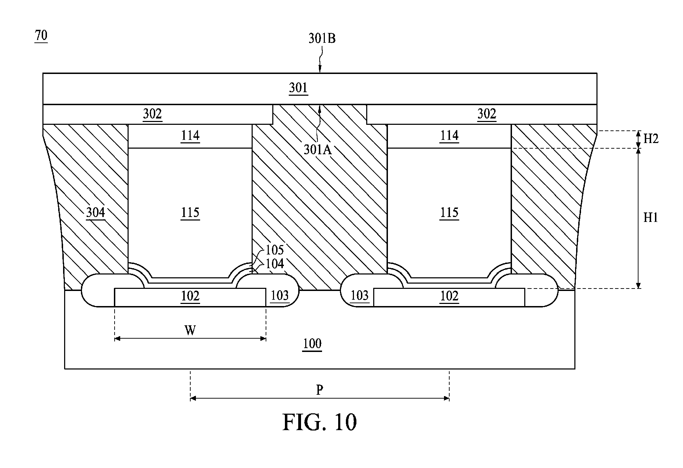

Referring to FIG. 10, a cross section of a chip-on-film (COF) semiconductor package 70 is shown. In FIG. 10, elements with identical numeral labels as those shown in FIG. 6 are referred to same elements or their equivalents and are not repeated here for simplicity. In FIG. 10, two pillar structures including Ag₁₋ₓYₓ alloy pillars 115 and covering members 114, electrically couple the device 100 to the conductive layers 302 of the flexible film 301. In some embodiments, an underfill material 304, for example, solventless epoxy resin, with appropriate viscosity is injected into the space between the flexible film 301 and the device 100.

The Ag₁₋ₓYₓ alloy pillar 115 shown in FIG. 10 includes Ag₁₋ₓYₓ alloy, wherein specie Y is gold, palladium, or the combination thereof. For example, Ag₁₋ₓYₓ alloy can be binary metal alloys such as Ag₁₋ₓAuₓ or Ag₁₋ₓPdₓ, furthermore, Ag₁₋ₓYₓ alloy can be ternary metal alloy such as Ag₁₋ₓ(AuPd)ₓ. In some embodiments, the content of the specie Y in the Ag₁₋ₓYₓ alloy is ranged from about 0.005 to about 0.25 in atomic percent. In some embodiments, specie Y in the Ag₁₋ₓYₓ alloy includes metal forming complete solid solution with silver at any weight percentage.

In FIG. 10, the covering member 114 is bonded with the conductive layer 302, so that the device 100 is electrically connected with the flexible film 301 by heat treatment such as reflow. In some embodiments, the covering member 114 includes solder material such as tin or silver.

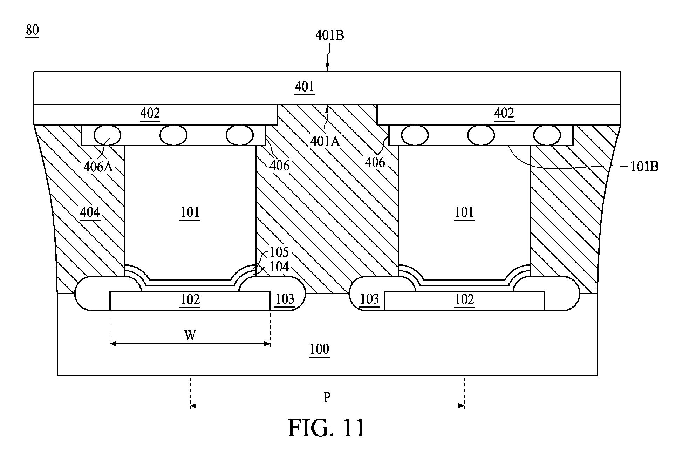

In some embodiments of the present disclosure, as shown in FIG. 11, the silver alloy bump 101 discussed herein can also be used in a chip-on-glass (COG) semiconductor package 80. A conductive trace 402 on a first surface 401A of a transparent substrate 401 is electrically connected with the silver alloy bump 101 of a device 100 by an anisotropic conductive film (ACF) 406. In some embodiments, the transparent substrate 401 is a glass substrate. In some embodiments, the ACF 406 includes Au-coated plastic sphere 406A with a diameter of from about 3µm to about 5µm, dispersed in a thermal setting epoxy matrix. In some embodiments, the boding temperature for using ACF 406 in the COG semiconductor package 80 is about 200 degrees Celsius.

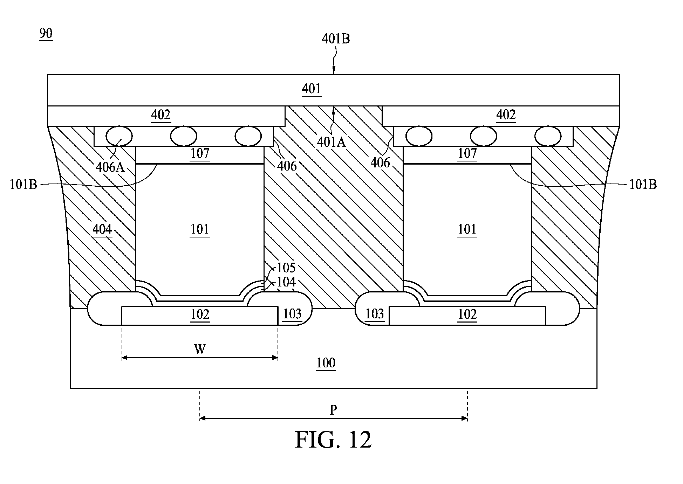

In some embodiments of the present disclosure, as shown in FIG. 12, the multilayer bump structure discussed herein can also be used in a chip-on-glass (COG) semiconductor package 90. The conductive trace 402 on a first surface 401A of the glass substrate 401 is electrically connected with the silver alloy bump 101 of the device 100 by the anisotropic conductive film (ACF) 406. In some embodiments, the conductive trace 402 is made of transparent and conductive materials such as indium tin oxide (ITO). In some embodiments, the ACF 406 includes Au-coated plastic sphere 406A with a diameter of from about 3µm to about 5µm, dispersed in a thermal setting epoxy matrix. In some embodiments, the bonding temperature for using the ACF 406 in the COG semiconductor package 90 is about 200 degrees Celsius. In some embodiments, the metal layer 107 disposed on the silver alloy bump 101 is an electroplated gold film with a thickness of from about 1µm to about 3µm. Under this circumstance, the bonding operation conventional to the gold bump art can be utilized in connecting the silver alloy bump 101 with the conductive trace 402.

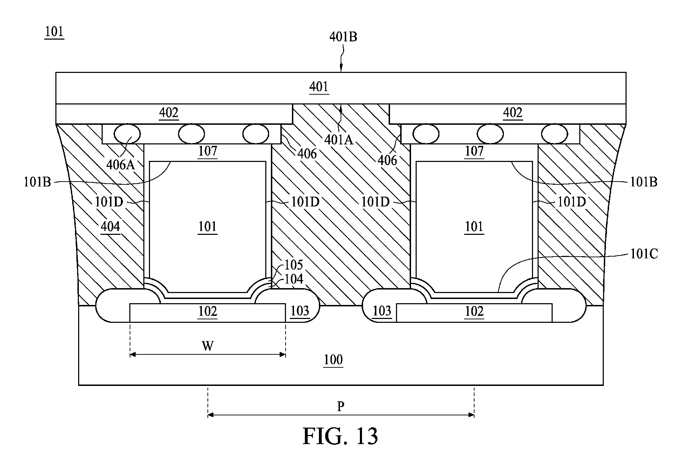

In some embodiments of the present disclosure, as shown in FIG. 13, the multilayer bump structure discussed herein can also be used in a chip-on-glass (COG) semiconductor package 101. The electrical connection between the conductive trace 402 on a first surface 401A of a glass substrate 401 and the silver alloy bump 101 is an anisotropic conductive film (ACF) 406. For example, the ACF 406 includes Au-coated plastic sphere 406A with a diameter of from about 3µm to about 5µm, dispersed in a thermal setting epoxy matrix. In some embodiments, the bonding temperature for using ACF 406 in a COG semiconductor package 101 is about 200 degrees Celsius. In some embodiments, the metal layer 107 disposed on the silver alloy bump 101 is an electroplated gold film with a thickness of from about 1µm to about 3µm, covering a top surface 101B and a sidewall 101D of the silver alloy bump 101. Under this circumstance, the bonding operation conventional to the gold bump art can be utilized in connecting the silver alloy bump 101 and the conductive trace 402 through the ACF 406 and the metal layer 107. In some embodiments, a thickness of the metal layer 107 on the top surface 101B is different from a thickness of the metal layer 107 covering the sidewall 101D of the silver alloy bump 101.

The hardness of the silver alloy bump and the silver cap discussed herein can be easily adjusted by selecting appropriate electroplating baths. For example, the hardness of the silver alloy bump for COG application as in FIG. 11, FIG. 12 and FIG. 13 can be adjusted to about 100 HV. For another example, the hardness of the silver alloy bump for COF application as in FIG. 6 and FIG. 8 can be adjusted to about 55 HV. Because the hardness of pure silver (about 85 HV) is situated between 55 HV and 100 HV, a silver alloy with desired hardness can be tailored by electroplating the silver alloy bump using different electroplating baths. In some embodiments, the COG application requires a silver alloy bump having a greater hardness to facilitate the ACF bonding operation. In other embodiments, the COF application requires a silver alloy bump having a lower hardness to prevent damaging the conductive traces on the flexible film.

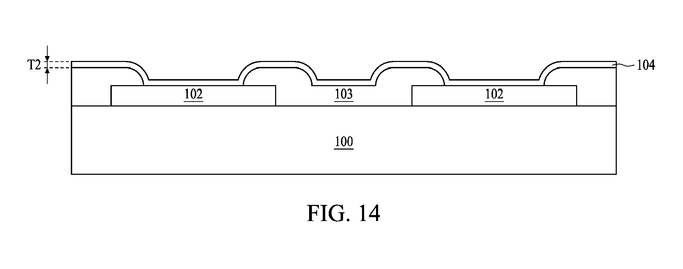

FIG. 14 to FIG. 19 show the manufacturing operation of the silver alloy pillar 115 of FIG. 5 described in the present disclosure. In FIG. 14, a UBM layer 104 is formed on a passivation layer 103 and a portion of a conductive pad 102. In some embodiments, the UBM layer 104 is formed by CVD, sputtering, electroplating, or electroless plating of the materials selected from nickel, titanium, titanium tungsten, palladium, gold, silver, and the combination thereof. In some embodiments, a thickness T2 of the UBM layer 104 is controlled to be in a range of from about 1000A to about 3000A.

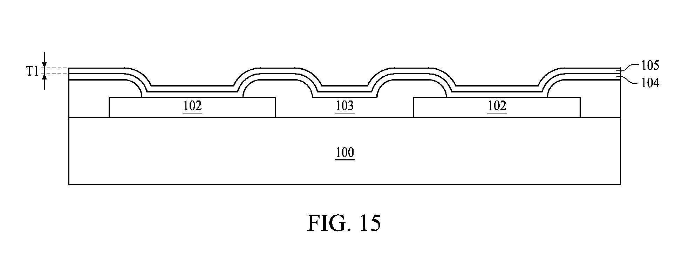

In FIG. 15, a seed layer 105 is deposited on the UBM layer 104. In some embodiments, the seed layer 105 is formed by CVD, sputtering, electroplating, or electroless plating of the materials containing silver. In some embodiments, a thickness T1 of the seed layer 105 is controlled to be commensurate to the thickness T2 of the UBM layer 104. For example, in a range of from about 1000A to about 3000A.

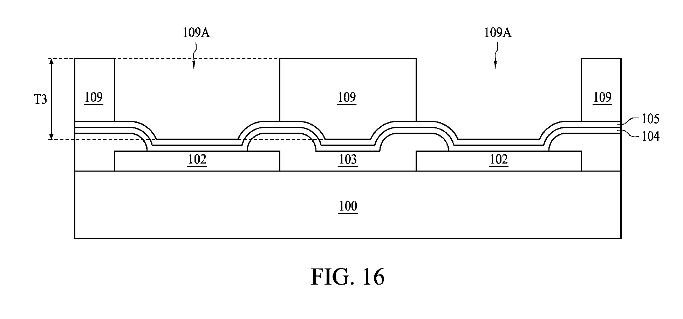

Referring to FIG. 16, a first mask layer 109, which can be a hard mask or a photoresist, is formed over the seed layer 105. An opening 109A of the first mask layer 109 is formed above the seed layer 105 and over the conductive pad 102. The opening 109A for receiving conductive pillar materials. In some embodiments, the first mask layer 109 is made of positive photoresist having a thickness T3 greater than a thickness of the conductive pillar to be plated. In other embodiments, the first mask layer 109 is made of negative photoresist.

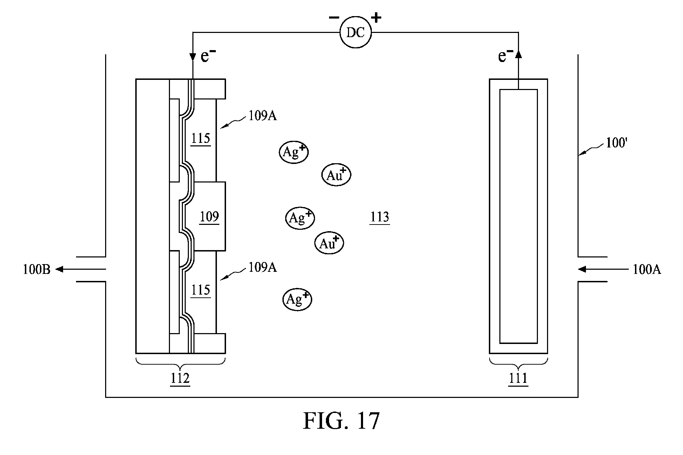

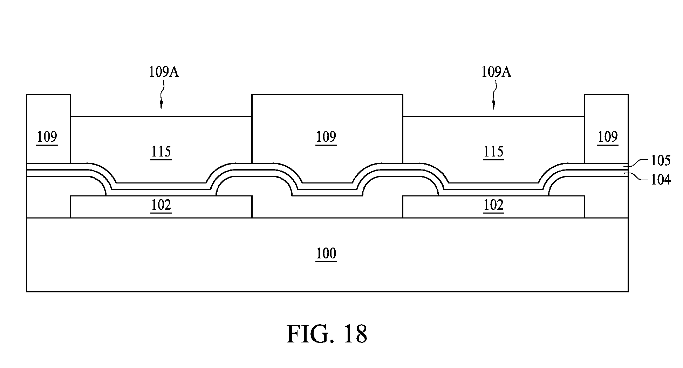

FIG. 17 shows the electroplating operation and FIG. 18 shows the result thereafter. FIG. 17 shows an electroplating system which includes a container 100' accommodating an electroplating bath 113, an anode 111, and a cathode 112. In some embodiments, the anode 111 is insoluble and can be made of platinum-coated titanium, the device 100 deposited with the seed layer 105 is positioned at the cathode 112, and the electroplating bath 113 contains cyanide-base plating solution including at least one of KAg(CN)₂, KAu(CN)₂, K₂Pd(CN)₄, and their salts.

In some embodiments, a direct current (DC) is applied to the device 100 connected to the cathode for reducing silver ions, gold ions or palladium ions on the seed layer 105 of the device 100. In some embodiments, the direct current (DC) has an electroplating current density in a range from about 0.1 ASD to about 1.0 ASD. In some embodiments, the pH value of the electroplating bath 113 is controlled around neutral, for example, from about 6 to about 8. A temperature of the electroplating bath 113 is controlled to be around 40 to 50 degrees Celsius. In some embodiments, the temperature of the electroplating bath 113 can be maintained by a thermal plate (not shown) positioned under the container 100'. In other embodiments, the temperature of the electroplating bath 113 can be maintained by an electroplating solution circulation system in which an outlet 100B discharges the electroplating solution and an inlet 100A intakes the temperature-controlled electroplating solution. Appropriate leveling agents including oxalate can be added to the electroplating bath 113 with a concentration of from about 2 ml/L to about 5 ml/L.

Referring to FIG. 17, the cathode 112 includes the device 100 deposited with the seed layer 105 containing silver or silver alloy, and the reaction occurs at the cathodes can be one of the following:

*KAg*(*CN*)*₂* → *K⁺* + *Ag*⁺ + 2*CN⁻*

*KAu*(*CN*)₂→*K*⁺ *+ Au*⁺ *+* 2*CN*⁻

*K₂Pd*(*CN*)₄→2*K*⁺ +*Pd*²⁺ *+* 4*CN*⁻

The anode 111 shown in FIG. 17 includes a platinum electrode and the reaction occurs thereon can be:

*2H₂O*→*4H*⁺ +*O*_{2(*g*)} +4*e⁻*

A positive end of the external DC current is connected to the anode 111 and a negative end of the external DC current is connected to the cathode 112. As can be seen in FIG. 17, reduced silver ions and reduced gold ions are deposited onto the seed layer 105 of the device 100, filling the openings 109A defined by the first mask layer 109 and forming AgAu binary alloy within the openings 109A.

In some embodiments, if the electroplating bath 113 includes silver ion source (for example, KAg(CN)₂) and palladium ion source (for example, K₂Pd(CN)₄), through the same electroplating operation setting described above, the reduced silver ions and reduced palladium ions are deposited onto the seed layer 105 of the device 100, filling the openings 109A defined by the first mask layer 109 and forming AgPd binary alloy within the openings 109A.

In some embodiments, if the electroplating bath 113 includes silver ion source (for example, KAg(CN)₂ and its salts), gold ion source (for example, KAu(CN)₂ and its salts), and palladium ion source (for example, K₂Pd(CN)₄ and its salts), through the same electroplating operation setting described above, the reduced silver ions, the reduced gold ions, and the reduced palladium ions are deposited onto the seed layer 105 of the device 100, filling the openings 109A defined by the first mask layer 109 and forming AgAuPd ternary alloy within the openings 109A.

After the electroplating operation shown in FIG. 17, the device 100 is removed from the electroplating bath 113 and the silver alloy pillars 115 including Ag₁₋ₓYₓ alloy are formed on the seed layer 105 as shown in FIG. 18. The Ag₁₋ₓYₓ alloy pillars 115 are formed over the conductive pads 102 and the device 100.

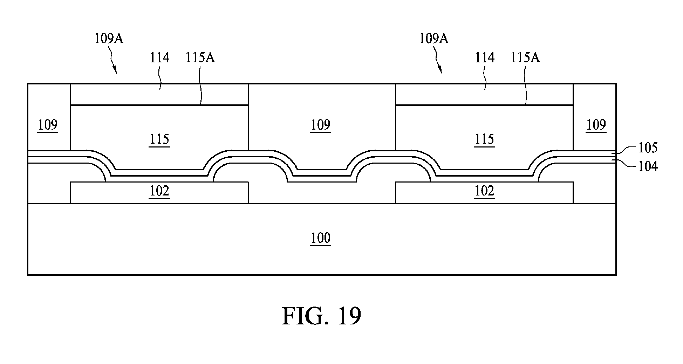

After the formation of the Ag₁₋ₓYₓ alloy pillars 115 within the opening 109A, a covering member 114 is formed on a top surface 115A of the Ag₁₋ₓYₓ alloy pillars 115 as shown in FIG. 19. In some embodiments, the covering member 114 includes a solder material such as tin or silver. In some embodiments, the covering member 114 is formed on the Ag₁₋ₓYₓ alloy pillars 115 by stencil printing, pasting, electroplating, electroless plating, or the like.

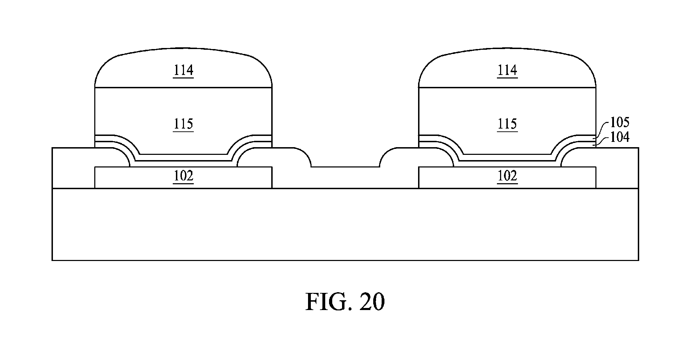

In FIG. 20, the first mask layer 109 is removed by stripping operation. Further, the UBM layer 104 and the seed layer 105 covered by the first mask layer 109 are also removed by etching operations so as to isolate the Ag₁₋ₓYₓ alloy pillars 115. In some embodiments, the covering member 114 is in a hemispherical shape as in FIG. 20 after a reflowing operation. In some embodiments, the covering member 114 is configured for bonding with a pad on an external device or a circuitry within an external device, so that the device 100 is electrically connected with the external device through the Ag₁₋ₓYₓ alloy pillars 115 and the covering member 114.

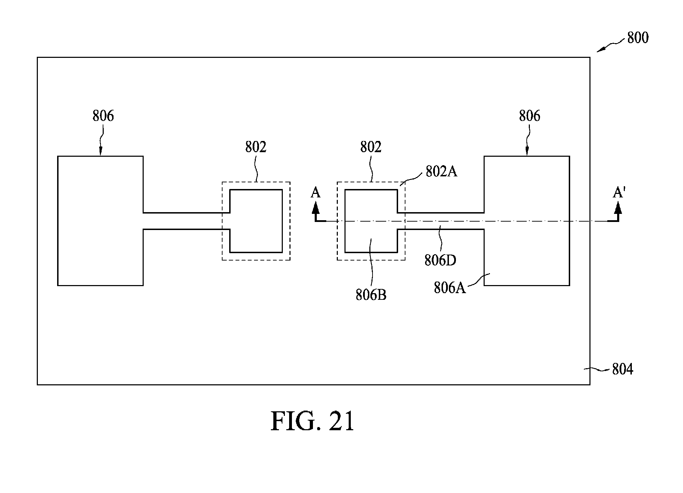

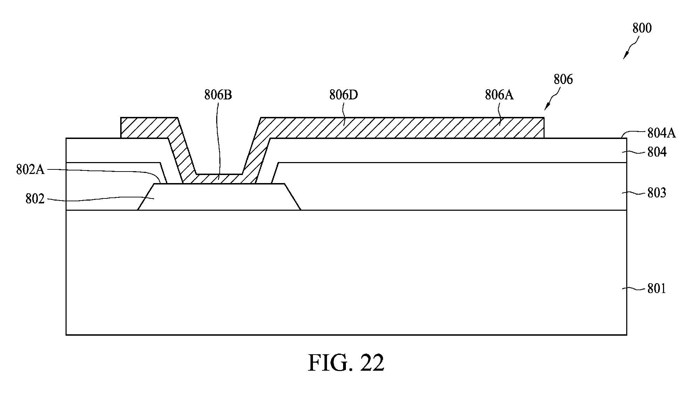

In some embodiments of the present disclosure, the silver alloy including Ag₁₋ₓYₓ alloy discussed herein can also be used for forming a redistribution layer (RDL) 806 within a semiconductor structure 800 as shown in FIG. 21 and FIG. 22. The RDL 806 re-routes a path of a circuit within the semiconductor structure 800 from a pad 802 to a land portion 806A. The land portion 806A is configured for receiving a conductive wire such as a gold wire or a conductive bump such as a solder ball, so that the semiconductor structure 800 is electrically connected with another external device by bonding a bond pad on the external device with the conductive bump.

FIG. 21 shows a top view of the RDL 806 of the semiconductor structure 800. The RDL 806 includes the land portion 806A, a via portion 806B and a runner portion 806D connecting the land portion 806A and the via portion 806B. In some embodiments, the RDL 806 including the Ag₁₋ₓYₓ alloy is formed over a passivation layer 803 or a polymeric layer 804 by electroplating, sputtering or etc. In some embodiments, the via portion 806B passes through the passivation layer 803 and the polymeric layer 804. In some embodiments, the via portion 806B electrically connects with the pad 802.

In some embodiments, the RDL 806 includes the Ag₁₋ₓYₓ alloy which can be a binary alloy or a ternary alloy with 0.005 to 0.25 atomic percent of non-silver elements. In some embodiments, the RDL 806 includes an electroplated Ag₁₋ₓYₓ alloy, wherein Y includes at least one of palladium (Pd) and gold (Au) and X is about 0.005 to about 0.25. In some embodiments, Ag₁₋ₓYₓ alloy is binary metal alloys such as Ag₁₋ₓAuₓ or Ag₁₋ₓPdₓ. In some embodiments, Ag₁₋ₓYₓ alloy is ternary metal alloy such as Ag₁₋ₓ(AuPd)ₓ. In some embodiments, the content of the specie Y in the Ag₁₋ₓYₓ alloy is ranged from about 0.005 to about 0.25 in atomic percent.

FIG. 22 shows a cross sectional view of the semiconductor structure 800 along AA' of FIG. 21. In some embodiments as in FIG. 22, the semiconductor structure 800 includes a device 801 such as a die or a substrate. In some embodiments, a pad 802 is disposed on the device 801. The pad 802 is a contact terminal for connecting a circuit within the device 801 with an external circuit or device. In some embodiments, a passivation layer 803 such as silicon oxynitride or silicon nitride is disposed over the device 801 and covers a portion of the top surface 802A of the pad 802. In some embodiments, a polymeric material 804 such as polyimide or polybenzoxazole (PBO) is disposed over the pad 802 and the passivation layer 803.

In some embodiments, the RDL 806 is disposed over the passivation layer 803 and the device 801. In some embodiments, the RDL 806 is disposed on a top surface 804A of the polymeric material 804. In some embodiments, the land portion 806A is configured for receiving the conductive wire or the conductive bump, so that the device 801 can be electrically connected with another semiconductor structure through the conductive wire or the conductive bump. In some embodiments, the land portion 806A is configured for a subsequent wire bonding operation. The land portion 806A receives an end of a metal wire, so that the land portion 806A electrically connects with an external circuit bonded with another end of the metal wire. In some embodiments, the land portion 806A receives the conductive bump which is configured for bonding on a bond pad of another semiconductor structure.

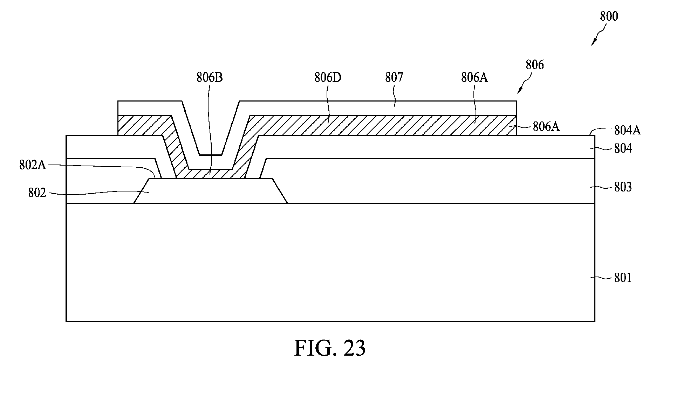

FIG. 23 shows a cross sectional view of the semiconductor structure 800 along AA' of FIG. 21. In some embodiments, the RDL 806 is a multilayer structure including the Ag₁₋ₓYₓ alloy and an additional metal layer 807 disposed on the RDL 806 electroplated with the Ag₁₋ₓYₓ alloy. In some embodiments, the additional metal layer 807 includes gold (Au). In some embodiments, the metal layer 807 is formed by an electroplating operation. In some embodiments, the metal layer 807 above the land portion 806A is configured for receiving a conductive wire such as a gold wire or a conductive bump such as a solder ball, so that the semiconductor structure 800 is electrically connected with another external device by bonding a bond pad on the external device with the conductive bump or the gold wire.

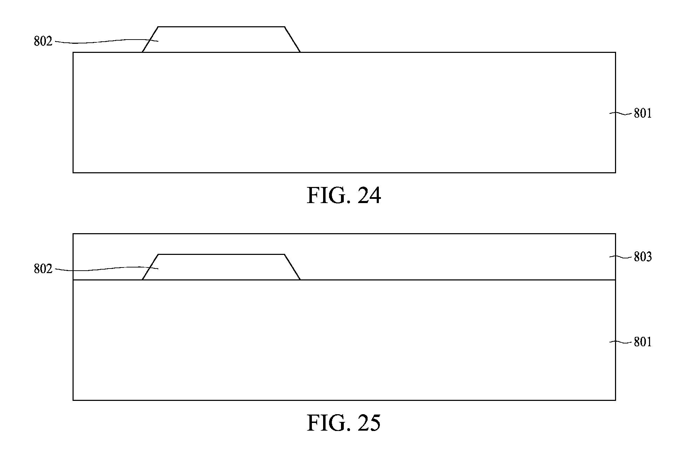

FIG. 24 to FIG. 31 show the manufacturing operation of the semiconductor structure 800 with the RDL 806 including the Ag₁₋ₓYₓ alloy as in FIG. 21 to FIG. 23. In FIG. 24, a device 801 and a pad 802 are provided. The pad 802 is disposed on the device 801. In some embodiments, the device 801 is a die or a substrate including a component and a circuit connecting the component. In some embodiments, the pad 802 includes aluminum.

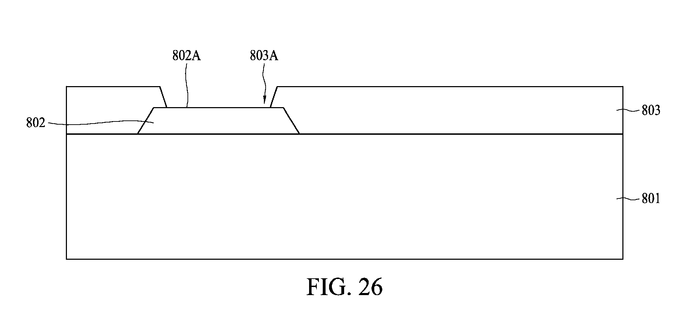

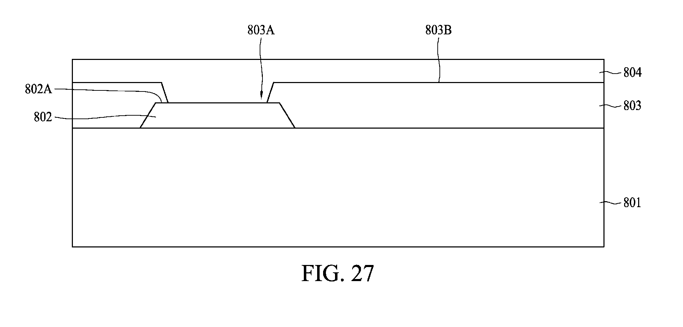

In FIG. 25, a passivation layer 803 is disposed over the device 801 and the pad 802. In some embodiments, the passivation layer 803 is formed with dielectric materials such as silicon oxide, silicon oxynitride, silicon nitride or etc. In FIG. 26, an opening 803A is formed above the top surface 802A of the pad 802 by an etching operation. In FIG. 27, a polymeric material 804 is disposed over the pad 802 and the passivation layer 803. The polymeric material 804 fills the opening 803A and extends along a top surface 803B of the passivation layer 803.

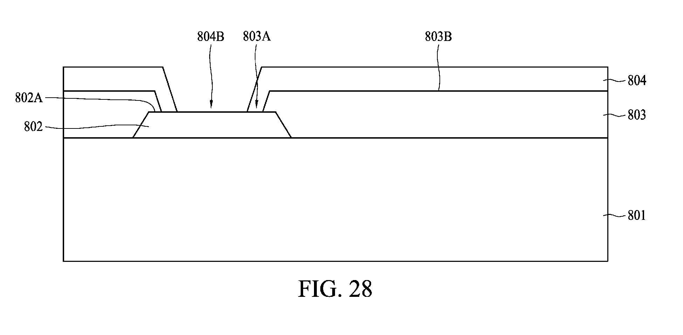

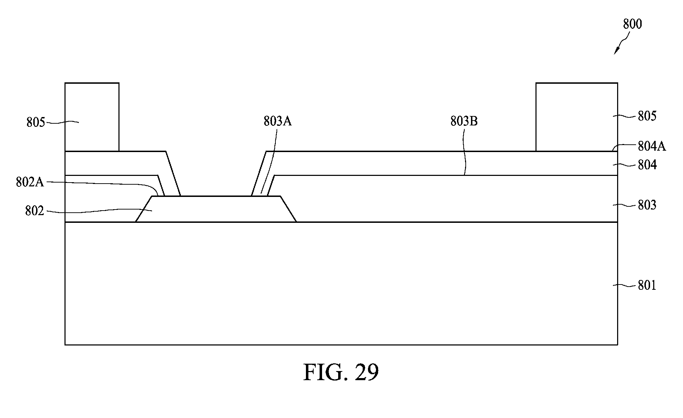

In FIG. 28, an opening 804B is formed above the top surface 802A of the pad 802 and within the opening 803A of the passivation layer 803. In some embodiments, the opening 804B is formed by etching operation. In FIG. 29, a mask layer 805 is disposed on the top surface 804A of the polymeric material 804 in a predetermined pattern. In some embodiments, the mask layer 805 can be a hard mask or a photoresist. The mask layer 805 is made of positive or negative photoresist. In some embodiments, the predetermined pattern of the mask layer 805 is formed by lithography operation, so that a portion of the top surface 804A of the polymeric material 804 is covered by the mask layer 805.

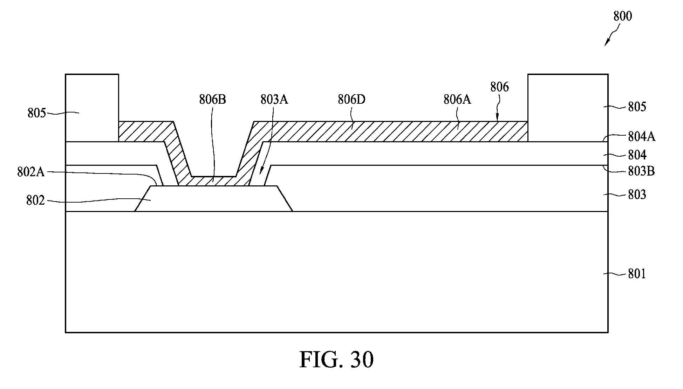

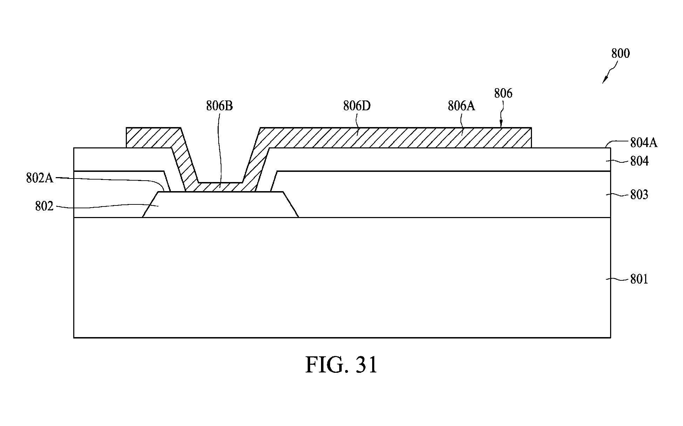

In FIG. 30, the RDL 806 is formed on the polymeric layer 804. The RDL 806 is formed by electroplating the Ag₁₋ₓYₓ alloy. In some embodiments, the semiconductor device 800 is immersed in an electroplating bath containing cyanide-base plating solution which includes at least one of KAg(CN)₂, KAu(CN)₂, K₂Pd(CN)₄, and their salts. The semiconductor device 800 connects to a cathode, such that silver ions, gold ions and palladium ions are reduced from the plating solution and are deposited onto the polymeric layer 804, and thus the RDL 806 including AgAu binary alloy (Ag₁₋ₓAuₓ), AgPd (Ag₁₋ₓPdₓ) binary alloy or AgAuPd ternary alloy (Ag₁₋ₓ(AuPd)ₓ) is formed. In some embodiments, X is ranged from about 0.005 to about 0.25 in atomic percent. In some embodiments, a direct current (DC) is applied to the semiconductor device 800 connected to the cathode for reducing silver ions, gold ions or palladium ions on the polymeric layer 804 of the semiconductor device 800. The direct current has an electroplating current density in a range from about 0.1 ASD to about 1.0 ASD. In FIG. 31, the mask layer 805 is removed by stripping operation, and thus the RDL 806 with electroplated Ag₁₋ₓYₓ alloy is formed.

In some embodiments, the RDL 806 is a multilayer structure as in FIG. 23, and thus an additional metal layer 807 is disposed on the RDL 806 electroplated with Ag₁₋ₓYₓ alloy. In some embodiments, the metal layer 807 is formed on the RDL 806 by electroplating operation before stripping of the mask layer 805. In some embodiments, the metal layer 807 is formed on the RDL 806 by an electroless plating operation.

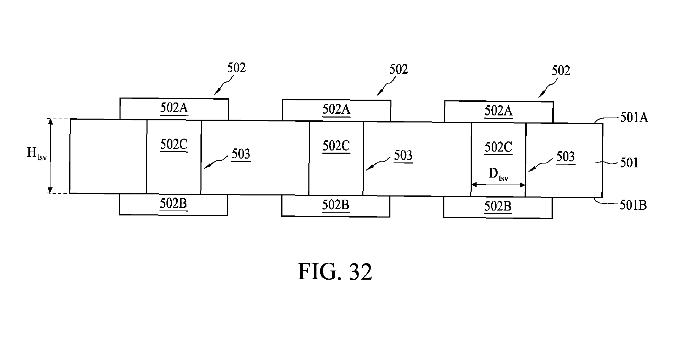

In some embodiments of the present disclosure, the silver alloy including Ag₁₋ₓYₓ alloy discussed herein can also be used for filling a through silicon via (TSV) passing through a die, a wafer, an interposer or a substrate as shown in FIG. 32 to FIG. 34. FIG. 32 shows a die 501 including a first surface 501A and a second surface 501B opposite to the first surface 501A.

In some embodiments, the die 501 has several TSV 503 plated with the Ag₁₋ₓYₓ alloy. The TSV 503 passes through the die 501 from the first surface 501A to the second surface 501B. In some embodiments, the TSV 503 is filled by the Ag₁₋ₓYₓ alloy which can be a binary alloy or a ternary alloy with 0.005 to 0.25 atomic percent of non-silver elements. In some embodiments, Y of the Ag₁₋ₓYₓ alloy includes at least one of palladium (Pd) and gold (Au) and X is from about 0.005 to about 0.25. In some embodiments, the TSV 503 has a high aspect ratio. In some embodiments, the aspect ratio of the TSV 503 is from about 3 to about 20. In some embodiments, the TSV 503 has a diameter Dₜₛᵥ of from about 1um to about 100um and has the height Hₜₛᵥ of from about 5um to about 500um.

In some embodiments, the TSV 503 is filled by the Ag₁₋ₓYₓ alloy by an electroplating operation to form a metallic structure 502. In some embodiments, the metallic structure 502 includes a first pad 502A on the first surface 501A, a second pad 502B on the second surface 501B, and an elongated portion 502C extending from the first surface 501A to the second surface 501B. In some embodiments, the first pad 502A and the second pad 502B are configured for receiving another pad on an external die. In some embodiments, the first pad 502A and the second pad 502B are configured for receiving a conductive pump or conductive pillar so as to be bonded with an external die. In some embodiments, the first pad 501A is disposed on the first surface 501A at an end of the TSV 503, and the second pad 502B is disposed on the second surface 501B at another end of the TSV 503. In some embodiments, the first pad 502A and the second pad 502B respectively include silver or gold.

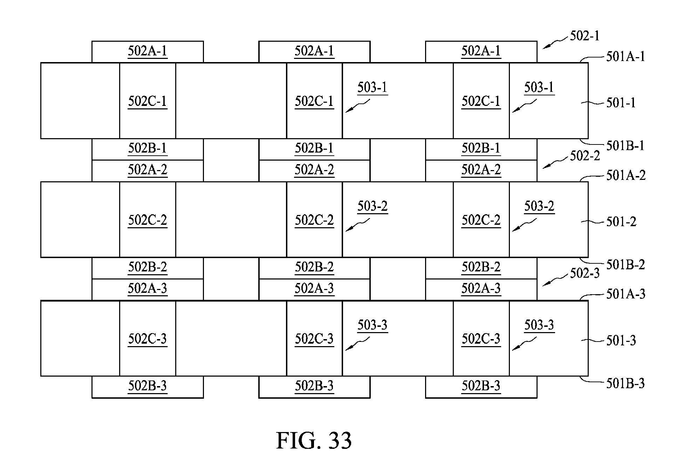

FIG. 33 shows several dies (501-1, 501-2, 501-3) stacking up and interconnected with each other by bonding of metallic structures (502-1, 502-2, 502-3) of the TSVs (503-1, 503-2, 503-3). In some embodiments, the dies (501-1, 501-2, 501-3) are stacked up so that the TSVs (503-1, 503-2, 503-3) are vertically aligned with each other. In some embodiments, each of the dies (501-1, 501-2, 501-3) is a dynamic random access memory (DRAM) die for data storage application. As shown in FIG. 33, three DRAM dies are stacked on each other to become a stacked memory chip.

In some embodiments, each of the metallic structures (502-1, 502-2, 502-3) are made of the Ag₁₋ₓYₓ alloy by electroplating operation. In some embodiments, Y of the Ag₁₋ₓYₓ alloy includes at least one of palladium (Pd) and gold (Au) and X is from about 0.005 to about 0.25.

In some embodiments, the TSV 503-1 of the die 501-1 is aligned with the TSV 503-2 of the die 501-2, and a second pad 502B-1 on a second surface 501B-1 of the die 501-1 is bonded with a first pad 502A-2 on a first surface 501A-2 of the die 501-2. As such, the die 501-1 and the die 501-2 are electrically connected through the TSV 503-1 and the TSV 503-2 from a first pad 502A-1 on a first surface 501A-1 to a second pad 502B-2 on a second surface 501B-2. Similarly, the TSV 503-2 of the die 501-2 is aligned with the TSV 503-3 of the die 501-3, and the second pad 502B-2 on the second surface 501B-2 is bonded with a first pad 502A-3 on a first surface 501A-3 of the die 501-3. As such, the die 501-2 and the die 501-3 are electrically connected through the TSV 503-2 and the TSV 503-3 from the first pad 502A-2 on the first surface 501A-2 to a second pad 502B-3 on a second surface 501B-3, and ultimately the dies (501-1, 501-2, 501-3) are electrically connected through the TSVs (503-1, 503-2, 503-3) from the first pad 502A-1 on the first surface 501A-1 to the second pad 502B-3 on the second surface 501B-3.

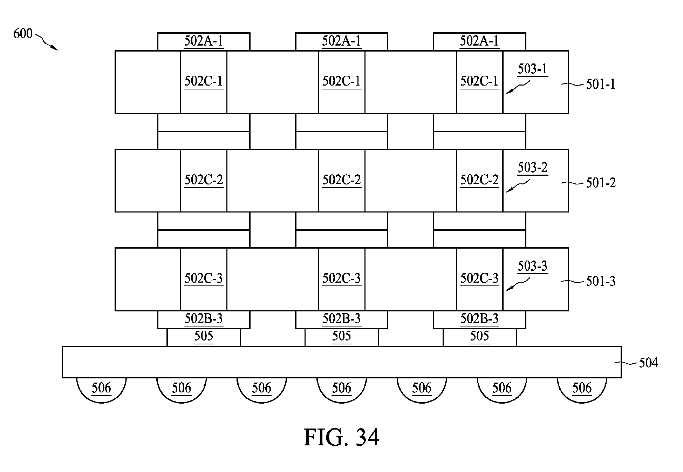

FIG. 34 shows a stacked dies (501-1, 501-2, 501-3) of FIG. 33 mounts on an interposer or a substrate 504. In some embodiments, the substrate 504 is made of silicon, ceramic or etc for carrying circuits and supporting components such as transistors. In some embodiments, the substrate 504 includes several bond pads 505 for receiving the second pads 502B-3 of the die 501-3 or conductive bumps respectively disposed on the second pads 502B-3. In some embodiments, the bond pads 505 includes pre-solder material to facilitate a subsequent bonding operation. In some embodiments, the bond pads 505 are mounted with conductive bumps respectively so that the conductive bumps can be bonded with the second pads 502B-3 on the die 501-3.

In some embodiments, the bond pads 505 are electrically connected with the second pads 502B-3 by any suitable bonding operation such as fusion bonding, thermo compression bonding, adhesion by ACF or etc. After the bonding of the second pad 502B-3 and the bond pad 505, the dies (501-1, 501-2, 501-3) are electrically connected with a circuit within the substrate 504. In some embodiments, the first pad 502A-1 of the die 501-1 is electrically communicateable with conductive bumps 506 disposed at a bottom of the substrate 504 through the TSVs (503-1, 503-2, 503-3) and the bond pads 505.

In some embodiments, the conductive bumps 506 of the substrate 504 can further mount on another substrate or device so as to further connect the dies (501-1, 501-2, 501-3) and the substrate 504 with another substrate or device to become a semiconductor package.

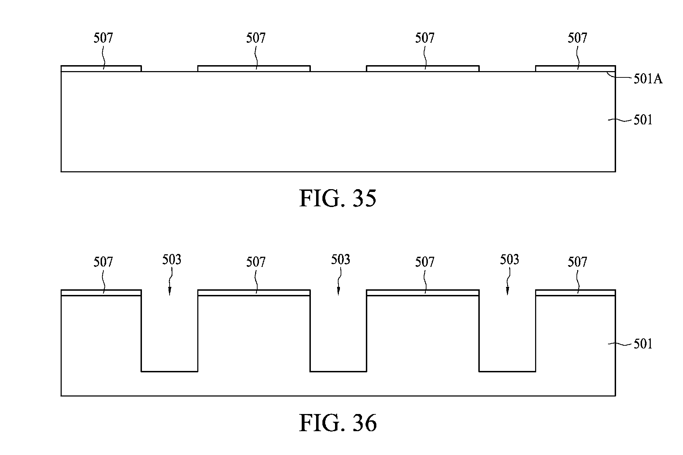

FIG. 35 to FIG. 41 show the manufacturing operation of the semiconductor structure with the TSVs filled by the Ag₁₋ₓYₓ alloy as in FIG. 32. In FIG. 35, a die 501 and a mask layer 507 with a predetermined pattern are provided. In some embodiments, the mask layer 507 is made of photoresist and is disposed on a first surface 501A of the die 501 in the predetermined pattern. In some embodiments, the predetermined pattern of the mask layer 507 is formed by a lithography operation, so that a portion of a first surface 501A of the die 501 is covered by the mask layer 507.

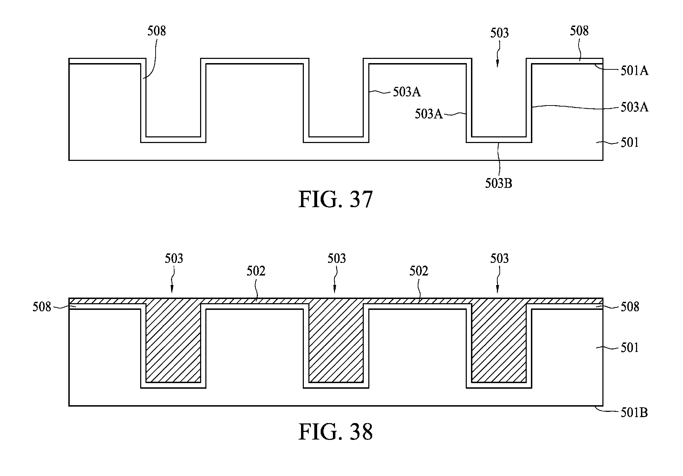

In FIG. 36, several vias 503 in a high aspect ratio is formed. In some embodiments, the vias 503 are formed by an etching operation or by a laser drilling operation. Some portions of the die 501 without coverage of the mask layer 507 are removed to form the vias 503. In some embodiments, the vias 503 are formed by deep reactive ion etching (DRIE). In FIG. 37, the mask layer 507 is removed by a stripping operation, and a seed layer 508 is disposed on the first surface 501A of the die 501, a sidewall 503A of the via 503 and a bottom surface 503B of the via 503. In some embodiments, the seed layer 508 is prepared by a suitable operation such as chemical vapor deposition (CVD), sputtering, electroplating or etc. In some embodiments, the seed layer 508 includes a silver or silver alloy.

In FIG. 38, a silver alloy 502 is disposed on the seed layer 508 and fills the vias 503. In some embodiments, the silver alloy 502 includes Ag₁₋ₓYₓ alloy wherein specie Y is gold, palladium, or the combination thereof. For example, Ag₁₋ₓYₓ alloy can be binary metal alloys such as Ag₁₋ₓAuₓ or Ag₁₋ₓPdₓ, furthermore, Ag₁₋ₓYₓ alloy can be ternary metal alloy such as Ag₁₋ₓ(AuPd)ₓ. In some embodiments, the content of the specie Y in the Ag₁₋ₓYₓ alloy is ranged from about 0.005 to about 0.25 in atomic percent.

In some embodiments, the die 501 is immersed in an electroplating bath containing cyanide-base plating solution which includes at least one of KAg(CN)₂, KAu(CN)₂, K₂Pd(CN)₄, and their salts. The die 501 connects to a cathode, such that silver ions, gold ions and palladium ions are reduced from the plating solution and are deposited onto the seed layer 508, and thus the silver alloy 502 including AgAu binary alloy (Ag₁₋ₓAuₓ), AgPd (Ag₁₋ₓPdₓ) binary alloy or AgAuPd ternary alloy (Ag₁₋ₓ(AuPd)ₓ) is formed on the seed layer 508 and fills the vias 503. The vias 503 are plated with the silver alloy 502. In some embodiments, a direct current (DC) is applied to the die 501 connected to the cathode for reducing silver ions, gold ions or palladium ions on the seed layer 105 of the die 501. The direct current has an electroplating current density in a range from about 0.1 ASD to about 1.0 ASD.

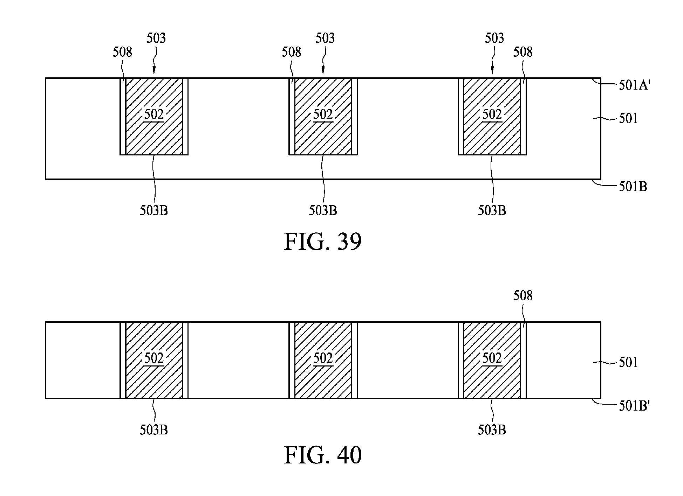

In FIG. 39, the die 501 is thinned from the first surface 501A by a thinning operation such as electro planarization, chemical mechanical polish (CMP) or the like. Some of the die 501 adjacent to the first surface 501A and some of the silver alloy 502 and the seed layer 508 overflowed from the via 508 are removed, such that the first surface 501A becomes a new first surface 501A' of the die 501, and the new first surface 501A' is at substantially same level as an exposed portion of the seed layer 508 and an exposed portion of the silver alloy 502.

In FIG. 40, the die 501 is thinned from a second surface 501B opposite to the first surface 501A by a thinning operation such as electro planarization, chemical mechanical polish (CMP) or etc, so that the bottom surface 503B of the silver alloy 502 is exposed from the die 501. In some embodiments, some of the die 501 are removed from the second surface 501B such that the second surface 501B becomes a new second surface 501B', and the bottom surface 503B of the silver alloy 502 is at substantially same level as the new second surface 501B' of the die 501.

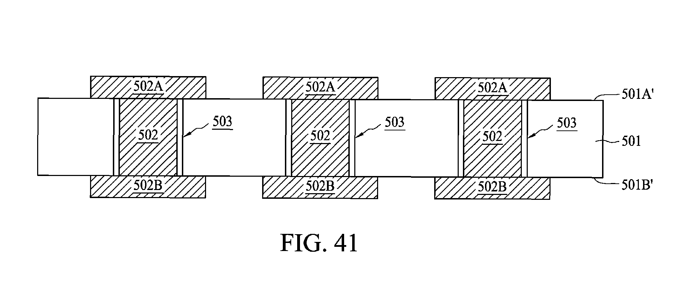

In FIG. 41, several pads (502A, 502B) are formed at ends of the silver alloy 502 respectively by any suitable operation such as electroplating. In some embodiments, the pads (502A, 502B) are made of same material as the silver alloy 502. In some embodiments, the pads (502A, 502B) include gold or silver. The pad 502A is electrically connected with the pad 502B through the via 503 plated with the silver alloy 502. In some embodiments, the pads (502A, 502B) are respectively configured for receiving a conductive bump or a bond pad disposed on an external die or substrate, so that the die 501 can be electrically connected with an external die or substrate by bonding the pad 502A or the pad 502B with a conductive bump or a bond pad disposed on an external die or substrate.

In some embodiments of the present disclosure, the silver alloy pillar structure 40 of FIG. 5 including Ag₁₋ₓYₓ alloy discussed herein can also be used for mounting a die on an external device such as a lead frame, a substrate or a PCB to become a semiconductor package such as quad flat package (QFP), quad flat no-leads (QFN) package, ball grid array (BGA) package, chip scale package (CSP), package on package (PoP), multi-chip module (MCM) or etc.

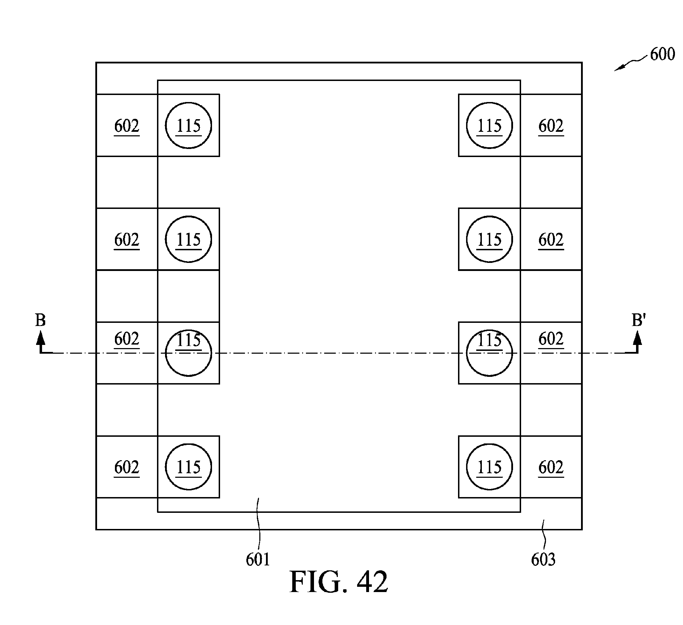

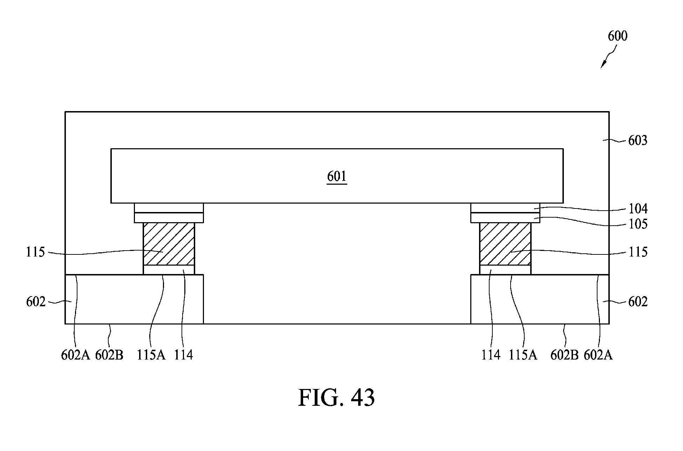

FIG. 42 shows a top view of a die 601 including several silver alloy pillars 115 connected with several contacts 602 to become a semiconductor package 600 as shown in FIG. 42 and FIG. 43. In some embodiments, the die 601 is a flip chip die which has an active side disposed with the silver alloy pillars 115. The active side of the die 601 is facing downward. In some embodiments, the contact 602 is a flat no-leads. The silver alloy pillars 115 disposed over the die 601 are bonded with the flat no-leads 602 to become a flip chip dual flat no-leads (FCDFN) package.

FIG. 43 shows a cross sectional view of the semiconductor structure 600 as the FCDFN package along BB' of FIG. 42. In some embodiments, the silver alloy pillars 115 are bonded with the flat no-leads 602. In some embodiments, the silver alloy pillars 115 includes an electroplated Ag₁₋ₓYₓ alloy, wherein Y includes at least one of palladium (Pd) and gold (Au) and X is from about 0.005 to about 0.25. In some embodiments, Ag₁₋ₓYₓ alloy is binary metal alloys such as Ag₁₋ₓAuₓ or Ag₁₋ₓPdₓ. In some embodiments, Ag₁₋ₓYₓ alloy is ternary metal alloy such as Ag₁₋ₓ(AuPd)ₓ. In some embodiments, the content of the specie Y in the Ag₁₋ₓYₓ alloy is ranged from about 0.005 to about 0.25 in atomic percent.

In some embodiments, the silver alloy pillars 115 are formed by an electroplating operation as shown in FIG. 17. The die 601 having the seed layer 105 and the UBM layer 104 is connected with a cathode. The die 601 is then immersed in an electroplating bath contains cyanide-base plating solution including at least one of KAg(CN)₂, KAu(CN)₂, K₂Pd(CN)₄, and their salts, such that silver ions are reduced from the plating solution and disposed on the seed layer 105 to form the silver alloy pillars 115 including AgAu binary alloy (Ag₁₋ₓAuₓ), AgPd (Ag₁₋ₓPdₓ) binary alloy or AgAuPd ternary alloy (Ag₁₋ₓ(AuPd)ₓ).

In some embodiments, the silver alloy pillars 115 are disposed on a seed layer 105 containing silver or silver alloy. In some embodiments, the seed layer 105 is disposed on an UBM layer 104 by any suitable operation such as sputtering. In some embodiments, the UBM layer 104 is disposed on the active side of the die 601. In some embodiments, the UBM layer 104 is a single-layer structure or a composite structure including several sub-layers formed of different materials. The UBM layer 104 includes a layer(s) selected from a nickel (Ni) layer, a titanium (Ti) layer, a titanium tungsten (W) layer, a palladium (Pd) layer, a gold (Au) layer, a silver (Ag) layer, and combinations thereof.

In some embodiments, the silver alloy pillars 115 disposed over the active side of the die 601 is bonded and electrically connected with the flat no-lead 602 by applying a solder material, a lead-free solder material or an ACF between the silver alloy pillars 115 and the flat no-leads 602. In some embodiments, a covering member 114 is disposed on a top surface 115A of the silver alloy pillar 115. In some embodiments, the covering member 114 is configured for bonding the silver alloy pillar 115 with a top surface 602A of the flat no-leads 602. In some embodiments, the covering member 114 includes a solder material such as tin or silver.

In some embodiments, the silver alloy pillars 115 is bonded with the flat no-leads 602 by any suitable operation such as fusion bonding, thermo compression bonding or etc, so that the top surface 115A of the silver alloy pillars 115 is interfaced with the top surface 602A of the flat no-lead 602. The die 601 is electrically connected with the flat no-leads 602 through the silver alloy pillars 115.

In some embodiments, the flat no-lead 602 has an exposed bottom surface 602B exposed for receiving another bond pad or a conductive bump of an external device. In some embodiments, a molding compound 603 covers the die 601 and the flat no-leads 602 to become the FCDFN package 600. In some embodiments, the exposed bottom surface 602B is exposed from the molding compound 603. In some embodiments, the molding compound 603 also fills a gap between the die 601, the silver alloy pillars 115 and the flat no-leads 602. In some embodiments, the molding compound 603 includes epoxy, polyimide, polybenzoxazole (PBO) or etc.

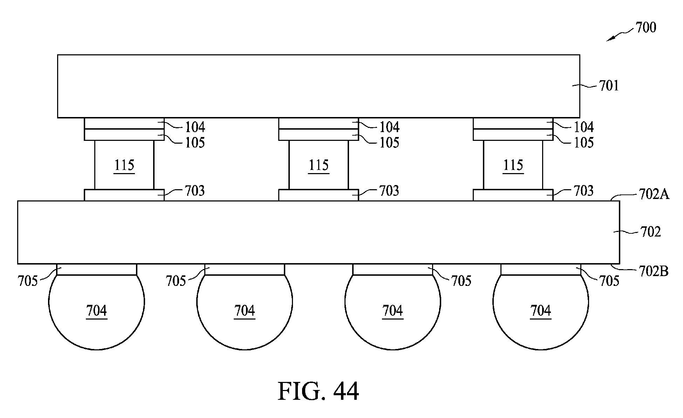

In some embodiments of the present disclosure, the silver alloy pillar structure 40 of FIG. 5 including Ag₁₋ₓYₓ alloy discussed herein can also be used for mounting a die 701 on a substrate 702 to become a BGA package as shown in FIG. 44. In FIG. 44, the die 701 is a flip chip die flipped over and mounted on the substrate 702 to become a flip chip ball grid array (FCBGA) package 700. In some embodiments, the silver alloy pillar 115 is bonded with a bump pad 703 on a first surface 702A of the substrate 702 by a reflow operation.

In some embodiments, the substrate 702 includes several conductive bumps 704 on a second surface 702B opposite to the first surface 702A. The conductive bump 704 is disposed on a ball pad 705 of the substrate 702. In some embodiments, the conductive bump 704 is a solder ball including solder material in a spherical shape. The conductive bump 704 is configured to be mounted on a bond pad on another substrate or a PCB, so that the die 701 is electrically connected with another substrate or the PCB through the silver alloy pillar 115 and the conductive bump 704.

In some embodiments, a semiconductor structure includes a device, a conductive pad over the device and a Ag₁₋ₓYₓ alloy pillar disposed on the conductive pad, wherein the Y of the Ag₁₋ₓYₓ alloy comprises metals forming complete solid solution with Ag at arbitrary weight percentage, and wherein the X of the Ag₁₋ₓYₓ alloy is in a range of from about 0.005 to about 0.25.

In some embodiments, the Y comprises at least one of Au and Pd. In some embodiments, the Ag₁₋ₓYₓ alloy pillar has a height of from about 30µm to about 100µm. In some embodiments, the semiconductor structure further includes a covering member disposed on the Ag₁₋ₓYₓ alloy pillar and including a solder material for electrically connecting with another semiconductor structure. In some embodiments, the covering member has a height of from about 1µm to about 5µm. In some embodiments, the covering member has a diameter substantially same as a diameter of the Ag₁₋ₓYₓ alloy pillar. In some embodiments, the conductive pad includes a seed layer including Ag or Ag alloy interfaced with the Ag₁₋ₓYₓ alloy pillar.

In some embodiments, a semiconductor structure includes a device, a conductive pad on the device, a passivation layer disposed over the device and covering a portion of the conductive pad and a redistribution layer (RDL) including Ag₁₋ₓYₓ alloy disposed over the passivation layer, wherein the Y of the Ag₁₋ₓYₓ alloy comprises metals forming complete solid solution with Ag at arbitrary weight percentage, and wherein the X of the Ag₁₋ₓYₓ alloy is in a range of from about 0.005 to about 0.25.

In some embodiments, the Y comprises at least one of Au and Pd. In some embodiments, the RDL is covered by a metal layer comprising gold. In some embodiments, the RDL includes a land portion for receiving a conductive wire or a conductive bump. In some embodiments, the RDL includes a via portion passing through the passivation layer and electrically connecting with the conductive pad.

In some embodiments, a semiconductor structure includes a die including a first surface and a second surface opposite to the first surface, and a via passing through the die from the first surface to the second surface, a Ag₁₋ₓYₓ alloy fills the via, and wherein the Y of the Ag₁₋ₓYₓ alloy comprises metals forming complete solid solution with Ag at arbitrary weight percentage, and wherein the X of the Ag₁₋ₓYₓ alloy is in a range of from about 0.005 to about 0.25.

In some embodiments, the Y comprises at least one of Au and Pd. In some embodiments, the via is a through silicon via (TSV) and has an aspect ratio of from about 3 to about 20. In some embodiments, the via has a height of from about 5um to about 500um. In some embodiments, the semiconductor structure further comprising a conductive pad disposed on the first surface or the second surface at an end of the via. In some embodiments, the conductive pad is configured for receiving a conductive bump, a conductive pillar or another conductive pad and for bonding with another semiconductor structure. In some embodiments, the conductive pad includes silver or gold. In some embodiments, the semiconductor structure further comprising a seed layer disposed between the Ag₁₋ₓYₓ alloy and a sidewall of the via.

In some embodiments, a die including an active side facing downward, a Ag₁₋ₓYₓ alloy pillar disposed over the active side of the die and a contact configured for bonding and electrically connecting with the Ag₁₋ₓYₓ alloy pillar, wherein the Y of the Ag₁₋ₓYₓ alloy comprises metals forming complete solid solution with Ag at arbitrary weight percentage, and wherein the X of the Ag₁₋ₓYₓ alloy is in a range of from about 0.005 to about 0.25.

In some embodiments, the Y comprises at least one of Au and Pd. In some embodiments, the contact is a flat no-lead which includes a top surface for receiving the Ag₁₋ₓYₓ alloy pillar and an exposed bottom surface for mounting on another semiconductor structure. In some embodiments, the flat no-lead bonds with the Ag₁₋ₓYₓ alloy pillar to become a flip chip dual flat no-leads (FCDFN) package. In some embodiments, the semiconductor structure further comprising a substrate including a first surface for disposing the contact and a second surface opposite to the first surface for disposing a plurality of conductive bumps arranged in a ball grid array (BGA). In some embodiments, the Ag₁₋ₓYₓ alloy pillar is bonded and electrically connected with the contact disposed on the substrate to become a flip chip ball grid array package (FCBGA).

In some embodiments, a method for manufacturing a semiconductor structure includes preparing a cyanide-base plating solution including at least one of KAg(CN)₂, KAu(CN)₂, K₂Pd(CN)₄, immersing the semiconductor structure into the plating solution, applying an electroplating current density of from about 0.1 ASD to about 1.0 ASD to the semiconductor structure to reduce silver ions, gold ions or palladium ions from the plating solution and forming a Ag₁₋ₓYₓ alloy structure on the semiconductor structure, wherein the Y of the Ag₁₋ₓYₓ alloy comprises metals forming complete solid solution with Ag at arbitrary weight percentage, and the X of the Ag₁₋ₓYₓ alloy is in a range of from about 0.005 to about 0.25.

In some embodiments, the forming the Ag₁₋ₓYₓ alloy structure on the semiconductor structure comprises electroplating a Ag₁₋ₓYₓ alloy pillar on a conductive pad disposed on a device of the semiconductor structure. In some embodiments, the forming the Ag₁₋ₓYₓ alloy structure on the semiconductor structure comprises electroplating a Ag₁₋ₓYₓ alloy RDL on a passivation layer disposed over a device of the semiconductor structure. In some embodiments, the method further comprising forming a metal layer on the Ag₁₋ₓYₓ alloy RDL by electroplating operation or electroless plating operation. In some embodiments, the forming the Ag₁₋ₓYₓ alloy structure includes forming a through silicon via (TSV) extending from a first surface of a die towards a second surface of the die opposite to the first surface, and filling the TSV with the Ag₁₋ₓYₓ alloy. In some embodiments, the forming the TSV includes disposing a mask layer on the first surface of the die in a predetermined pattern and removing a portion of the die from the first surface by an etching operation. In some embodiments, the forming the TSV includes a laser drilling operation. In some embodiments, the forming the Ag₁₋ₓYₓ alloy structure includes grinding the die from the second surface to expose the Ag₁₋ₓYₓ alloy.

Moreover, the scope of the present application is not intended to be limited to the particular embodiments of the process, machine, manufacture, and composition of matter, means, methods and steps described in the specification. As those skilled in the art will readily appreciate form the disclosure of the present disclosure, processes, machines, manufacture, compositions of matter, means, methods, or steps, presently existing or later to be developed, that perform substantially the same function or achieve substantially the same result as the corresponding embodiments described herein may be utilized according to the present disclosure.

Accordingly, the appended claims are intended to include within their scope such as processes, machines, manufacture, and compositions of matter, means, methods or steps. In addition, each claim constitutes a separate embodiment, and the combination of various claims and embodiments are within the scope of the invention.

## Claims

1. A semiconductor structure, comprising:
a device;
a conductive pad over the device; and
a Ag₁₋ₓYₓ alloy pillar disposed on the conductive pad,
wherein the Y of the Ag₁₋ₓYₓ alloy comprises metals forming complete solid solution with Ag at arbitrary weight percentage, and
wherein the X of the Ag₁₋ₓYₓ alloy is in a range of from about 0.005 to about 0.25.

2. The semiconductor structure of Claim 1, wherein the Y comprises at least one of Au and Pd.

3. The semiconductor structure of Claim 1 or 2, wherein the Ag₁₋ₓYₓ alloy pillar has a height of from about 30µm to about 100µm and/or wherein the conductive pad includes a seed layer including Ag or Ag alloy interfaced with the Ag₁₋ₓYₓ alloy pillar.

4. The semiconductor structure of any of claims 1 to 3, further comprising a covering member disposed on the Ag₁₋ₓYₓ alloy pillar and including a solder material for electrically connecting with another semiconductor structure, wherein the covering member preferably has a height of from about 1µm to about 5µm.

5. The semiconductor structure of any of the preceding claims, further comprising a contact which includes a top surface for receiving the Ag₁₋ₓYₓ alloy pillar and an exposed bottom surface for mounting on another semiconductor structure, wherein the contact preferably is a flat no-lead which bonds with the Ag₁₋ₓYₓ alloy pillar to become a flip chip dual flat no-leads (FCDFN) package.

6. The semiconductor structure of any of the preceding claims, further comprising a substrate including a first surface for disposing a contact and a second surface opposite to the first surface for disposing a plurality of conductive bumps arranged in a ball grid array (BGA), and the contact of the substrate is bonded with the Ag₁₋ₓYₓ alloy pillar to become a flip chip ball grid array package (FCBGA).

7. A semiconductor structure, comprising:
a device;
a conductive pad on the device;
a passivation layer disposed over the device and covering a portion of the conductive pad; and
a redistribution layer (RDL) including Ag₁₋ₓYₓ alloy disposed over the passivation layer,
wherein the Y of the Ag₁₋ₓYₓ alloy comprises metals forming complete solid solution with Ag at arbitrary weight percentage, and
wherein the X of the Ag₁₋ₓYₓ alloy is in a range of from about 0.005 to about 0.25.

8. The semiconductor structure of Claim 7, wherein the Y comprises at least one of Au and Pd.

9. The semiconductor structure of Claim 7 or 8, wherein the RDL is covered by a metal layer comprising gold, wherein the RDL preferably includes a land portion for receiving a conductive wire or a conductive bump, or wherein the RDL preferably includes a via portion passing through the passivation layer and electrically connecting with the conductive pad.

10. A semiconductor structure, comprising:
a die including a first surface and a second surface opposite to the first surface; and
a via passing through the die from the first surface to the second surface,
a Ag₁₋ₓYₓ alloy filling the via, and
wherein the Y of the Ag₁₋ₓYₓ alloy comprises metals forming complete solid solution with Ag at arbitrary weight percentage, and
wherein the X of the Ag₁₋ₓYₓ alloy is in a range of from about 0.005 to about 0.25.

11. The semiconductor structure of Claim 10, wherein the Y comprises at least one of Au and Pd.

12. The semiconductor structure of Claim 10 or 11, wherein the via is a through silicon via (TSV) and has an aspect ratio of from about 3 to about 20, wherein the via preferably has a height of from about 5um to about 500um.

13. The semiconductor structure of any of claims 10 to 12, further comprising a conductive pad disposed on the first surface or the second surface at an end of the via, wherein the conductive pad preferably is configured for receiving a conductive bump, a conductive pillar or another conductive pad and for bonding with another semiconductor structure, and/or wherein the conductive pad preferably includes silver or gold.

14. The semiconductor structure of any of claims 10 to 13, further comprising a seed layer disposed between the Ag₁₋ₓYₓ alloy and a sidewall of the via.

15. A method for manufacturing a semiconductor structure, comprising:
preparing a cyanide-base plating solution including at least one of KAg(CN)₂, KAu(CN)₂, K₂Pd(CN)₄;
immersing the semiconductor structure into the plating solution;
applying an electroplating current density of from about 0.1 ASD to about 1.0 ASD to the semiconductor structure to reduce silver ions, gold ions or palladium ions from the plating solution; and
forming a Ag₁₋ₓYₓ alloy structure on the semiconductor structure,
wherein the Y of the Ag₁₋ₓYₓ alloy comprises metals forming complete solid solution with Ag at arbitrary weight percentage, and the X of the Ag₁₋ₓYₓ alloy is in a range of from about 0.005 to about 0.25.

16. The method of Claim 15, wherein the forming the Ag₁₋ₓYₓ alloy structure on the semiconductor structure comprises
electroplating a Ag₁₋ₓYₓ alloy pillar on a conductive pad disposed on a device of the semiconductor structure, or
electroplating a Ag₁₋ₓYₓ alloy RDL on a passivation layer disposed over a device of the semiconductor structure.

17. The method of Claim 15 or 16, further comprising forming a metal layer on the Ag₁₋ₓYₓ alloy RDL by electroplating operation or electroless plating operation.

18. The method of any of claims 15 to 17, wherein the forming the Ag₁₋ₓYₓ alloy structure includes forming a through silicon via (TSV) extending from a first surface of a die towards a second surface of the die opposite to the first surface, and filling the TSV with the Ag₁₋ₓYₓ alloy,
wherein the forming the TSV preferably includes
disposing a mask layer on the first surface of the die in a predetermined pattern and removing a portion of the die from the first surface by an etching operation; or
a laser drilling operation.

19. The method of any of claims 15 to 18, wherein the forming the Ag₁₋ₓYₓ alloy structure includes grinding the die from the second surface to expose the Ag₁₋ₓYₓ alloy.
